# EUROPEAN PATENT SPECIFICATION

(11) **EP 4 391 508 B1**
(45) Date of publication and mention of the grant of the patent: **15.10.2025**
(21) Application number: 23810792.4
(22) Date of filing: 05.05.2023
(51) Int. Cl.: H04W 4/02, H04M 1/72457, H04M 1/72454, H04W 4/80, H04M 1/725, G01R 33/02, G01R 33/07

(54) **METHOD AND APPARATUS FOR RECOGNIZING STATE OF TERMINAL**
VERFAHREN UND VORRICHTUNG ZUR ERKENNUNG DES ZUSTANDS EINES ENDGERÄTS
PROCÉDÉ ET APPAREIL DE RECONNAISSANCE D'ÉTAT D'UN TERMINAL

(30) Priority: 27.05.2022 CN 202210590877
(43) Date of publication of application: 26.06.2024
(73) Proprietor: Honor Device Co., Ltd., Shenzhen, Guangdong 518040 (CN)
(72) Inventor: DI, Haoxuan, Shenzhen, Guangdong 518040 (CN); GUO, Junlong, Shenzhen, Guangdong 518040 (CN); LI, Danhong, Shenzhen, Guangdong 518040 (CN); ZHANG, Xiaowu, Shenzhen, Guangdong 518040 (CN)
(74) Representative: Beder, Jens
(86) International application number: PCT/CN2023/092353
(87) International publication number: WO 2023/226719

(56) References cited:
- CN-A- 108 196 998
- CN-A- 109 947 331
- CN-A- 109 979 045
- CN-A- 111 353 467
- CN-A- 111 354 091
- CN-A- 116 055 629
- US-A1- 2016 091 593
- US-A1- 2016 306 338

## Description

This application claims priority to Chinese Patent Application No. 202210590877.5, filed with the China National Intellectual Property Administration on May 27, 2022 and entitled "TERMINAL STATE IDENTIFICATION METHOD AND APPARATUS",.

### TECHNICAL FIELD

This application relates to the field of terminal technologies, and in particular, to a terminal state identification method and apparatus.

### BACKGROUND

With the development of the transportation industry, subway travel becomes a relatively common mode of travel in urban transportation. In a period of taking a subway, a user needs to use an intelligent terminal.

In the conventional technology, a movement state of the terminal may be determined by reading data of an accelerometer of the terminal. In a current technology, a current state of getting on/off a subway carriage by the user cannot be accurately identified, and user experience is affected. Therefore, how to accurately identify a state of getting on/off a subway becomes an urgent problem to be resolved. Document CN 111 353 467 A describes a driving state recognition method and device, wherein the terminal collects acceleration and gravity data, that is used to calculate a probability matrix that indicates the probability of the mobile terminal being in each state. Travel related information can be presented based on the detected state. Document US 2016/306338 A1 describes a mobile phone including an acceleration sensor for detecting acceleration, a magnetic sensor for detecting magnetism, and a controller for determining a type of moving state based on the acceleration detected by the acceleration sensor and the magnetism detected by the magnetic sensor. Accordingly a task can be set when it is detected that the user gets on or off a train. Document CN 109 947 331 A describes an indication information display method and device and a storage medium, wherein travel information, e.g. a virtual travel card, is displayed based on the motion state of the terminal.

### SUMMARY

In view of this, this application provides a terminal state identification method and an electronic device, a computer-readable storage medium, and a chip, so that a scenario in which a terminal user gets on/off a subway carriage can be intelligently identified, to recommend a corresponding function to the user and improve experience of using an intelligent terminal when the user takes a subway.

According to a first aspect, a terminal state identification method is provided according to claim 1. The method includes:
obtaining acceleration data of a terminal by using an acceleration sensor;
obtaining magnetometer data of the terminal by using a magnetometer sensor;
determining a first probability value based on the acceleration data and the magnetometer data, where the first probability value is used to represent a probability that the terminal is in a subway state, and when the first probability value is greater than a first probability threshold, the terminal is in the subway state;
determining a state of a terminal user based on the first probability value, where the state of the terminal user includes a state of getting off a subway and a state of getting on a subway; and
displaying a first interface when determining that the terminal user is in the state of getting off a subway, where the first interface includes an exit card.

The method may be performed by a terminal device or a chip in a terminal device. Based on the foregoing solution, the acceleration data and the magnetometer data are obtained, the first probability value is determined based on the acceleration data and the magnetometer data, then the state of getting on/off a subway by the terminal user is determined with reference to the first probability value, and finally a boarding code for exit is displayed to the user when the state of getting off a subway is determined. In this way, it can be accurately identified whether the user is in the state of getting off a subway, and when the state of getting off a subway is identified, a to-be-used exit card function pops up or is pushed for the user in real time. This saves a time for the user to actively open the exit card, and provides a convenient service for the user.

In a possible implementation, the method further includes:
enabling a network acceleration module when determining that the terminal user is in the state of getting on a subway.

After a subway carriage is entered, signal quality in the carriage is relatively poor. Therefore, when the state of getting on a subway is intelligently determined, the network acceleration module of the terminal may be turned on or enabled for the user, to accelerate a network connection or perform network optimization, and improve Internet access experience of the user in the subway carriage.

The state of the terminal user may be determined based on the first probability value in two manners.

According to the invention, the determining a state of a terminal user based on the first probability value includes:
obtaining a plurality of first probability values in first preset duration;
obtaining, based on the plurality of first probability values, first duration that is in the first preset duration and in which the terminal is in the subway state;
determining whether the first duration is less than a first time threshold; and
when the first duration is less than the first time threshold, determining that the terminal user is in the state of getting off a subway.

Therefore, based on the first probability value, by determining a relationship between the first duration and the first time threshold, it may be quickly determined that the terminal user is in the state of getting off a subway.

Optionally, in another implementation, the method further includes: determining whether the first duration is greater than a second time threshold; and
when the first duration is greater than the second time threshold, determining that the terminal user is in the state of getting on a subway.

Therefore, based on the first probability value, by determining a relationship between the first duration and the second time threshold, it may be quickly determined that the terminal user is in the state of getting on a subway.

In addition to the first probability threshold, in this embodiment of this application, a second probability value may be further considered to determine a state of getting on/off a subway carriage by the terminal user.

In a possible implementation, the method further includes:
determining a second probability value based on the acceleration data, where the second probability value is used to represent a probability that the terminal user is in a walking state, and when the second probability value is greater than a second probability threshold, the terminal user is in the walking state; and
the determining a state of a terminal user based on the first probability value includes:
   determining the state of the terminal user based on the first probability value and the second probability value.

Therefore, the state of getting on/off a subway carriage by the terminal user is jointly determined by using the first probability value and the second probability value. This helps improve determining accuracy.

Specifically, the state of the terminal user may be jointly determined based on the first probability value and the second probability value in the following two manners:

In a possible manner, the determining the state of the terminal user based on the first probability value and the second probability value includes:
obtaining a plurality of first probability values in second preset duration;
obtaining, based on the plurality of first probability values, second duration that is in the second preset duration and in which the terminal user is in the subway state;
determining whether the second duration is less than a third time threshold;
obtaining a plurality of second probability values in third preset duration;
obtaining, based on the plurality of second probability values, third duration that is in the third preset duration and in which the terminal user is in the walking state;
determining whether the third duration is greater than a fourth time threshold; and
when the second duration is less than the third time threshold, and the third duration is greater than the fourth time threshold, determining that the terminal user is in the state of getting off a subway.

Therefore, based on the first probability value and the second probability value, it is jointly determined that the terminal user is in the state of getting off a subway. This can improve determining accuracy.

In another possible manner, the determining the state of the terminal user based on the first probability value and the second probability value includes:
obtaining a plurality of first probability values in second preset duration;
obtaining, based on the plurality of first probability values, second duration that is in the second preset duration and in which the terminal user is in the subway state;
determining whether the second duration is greater than a fifth time threshold;
obtaining a plurality of second probability values in fourth preset duration;
obtaining, based on the plurality of second probability values, fourth duration that is in the fourth preset duration and in which the terminal user is in the walking state;
determining whether the fourth duration is greater than a sixth time threshold; and
when the fourth duration is greater than the sixth time threshold, and the second duration is greater than the fifth time threshold, determining that the terminal user is in the state of getting on a subway.

Therefore, based on the first probability value and the second probability value, it is jointly determined that the terminal user is in the state of getting on a subway. This can improve determining accuracy.

In a possible implementation, the determining a first probability value based on the acceleration data and the magnetometer data includes:
calculating the first probability value based on the acceleration data and the magnetometer data by using a first binary classification network.

In a possible implementation, the determining a second probability value based on the acceleration data includes:
calculating the second probability value based on the acceleration data by using a second binary classification network.

In a possible implementation, after the enabling a network acceleration module, the method further includes:
displaying a prompt box to the user, where the prompt box includes a first option and a second option, the first option is used to choose to disable the network acceleration module, and the second option is used to choose to continue to enable the network acceleration module.

If the user taps the first option, the network acceleration module may be disabled, to avoid an increase in network traffic and reduce power consumption of the terminal. If the user taps the second option, a state of enabling the network acceleration module is maintained.

In a possible implementation, when it is determined that the state of the terminal user is the state of getting on a subway, the method further includes:
displaying a second interface, where the second interface includes a first pop-up window, and the first pop-up window is used to recommend public transportation navigation to the user. In this way, the user can query or use public transportation by using the first pop-up window. This improves user experience.

In a possible implementation, the method further includes:
displaying a first setting interface, where the first setting interface includes a subway setting control; and
entering a subway setting interface in response to an operation performed by the user on the subway setting control, where the subway setting interface includes a third option, and the third option is used to choose to enable or disable the network acceleration module in the subway state by default.

The user may preset, in the subway setting control, whether to enable the network acceleration module in the subway state by default. If the user sets that the network acceleration module in the subway state is enabled by default, the network acceleration module is automatically enabled after a subway scenario is intelligently identified (for example, the subway carriage is entered), to improve Internet access experience when the user takes the subway. If the user sets that the network acceleration module in the subway state is disabled by default, the network acceleration module is not automatically enabled even after a subway scenario is identified (for example, the subway carriage is entered), to reduce power consumption.

According to a second aspect, an electronic device is provided according to claim 12.

According to a third aspect, a computer-readable storage medium is provided according to claim 13.

According to a fourth aspect, a chip is provided according to claim 14.

### BRIEF DESCRIPTION OF DRAWINGS

FIG. 1 is an example diagram of an application scenario according to an embodiment of this application;
FIG. 2 is another example diagram of an application scenario according to an embodiment of this application;
FIG. 3 is a schematic diagram of a hardware system of an electronic device applicable to this application;
FIG. 4 is a schematic diagram of a software system of an electronic device applicable to this application;
FIG. 5 is a schematic flowchart of a terminal state identification method according to an embodiment of this application;
FIG. 6 is a diagram of comparison between magnetometer data of a vehicle and magnetometer data of a subway;
FIG. 7 is an example flowchart of calculating a subway probability value according to an embodiment of this application;
FIG. 8 is an example flowchart of determining a state of a terminal user according to an embodiment of this application;
FIG. 9 is an example diagram of an interface of a terminal presented after a user gets off a subway carriage;
FIG. 10A and FIG. 10B are a schematic diagram of another interface of a terminal presented after a user gets off a subway carriage;
FIG. 11A, FIG. 11B, and FIG. 11C are a schematic diagram of still another interface of a terminal presented after a user gets off a subway carriage;
FIG. 12 is an example diagram of an interface of a mobile phone presented when a user transfers to a subway;
FIG. 13 is an example flowchart of calculating a walking probability value according to an embodiment of this application;
FIG. 14 is another example flowchart of determining a state of a terminal user according to an embodiment of this application;
FIG. 15 is a schematic diagram of change trends of a first probability value and a second probability value when a terminal user gets off a subway;
FIG. 16 is still another example flowchart of determining a state of a terminal user according to an embodiment of this application;
FIG. 17 is a schematic diagram of another interface according to an embodiment of this application;
FIG. 18A and FIG. 18B are an example diagram of an interface of a setting option for smart travel according to an embodiment of this application;
FIG. 19A and FIG. 19B are an example diagram of a recommendation interface presented in a state of getting on a subway;
FIG. 20A and FIG. 20B are another example diagram of a recommendation interface presented in a state of getting on a subway;
FIG. 21 is still another example diagram of a recommendation interface presented in a state of getting on a subway;
FIG. 22A, FIG. 22B, and FIG. 22C are another example diagram of a recommendation interface presented in a state of getting on a subway; and
FIG. 23 is a schematic block diagram of a terminal state identification apparatus according to an embodiment of this application.

### DESCRIPTION OF EMBODIMENTS

The following describes the technical solutions in the embodiments of this application with reference to the accompanying drawings.

The technical solutions in the embodiments of this application are applied to a scenario in which a user takes an urban rail transit line with an intelligent terminal. A specific means of transportation for the urban rail transit line is not specifically limited in the embodiments of this application, for example, a subway, a light rail, or an urban rail. For ease of description, in the embodiments of this application, a subway is used as an example for description. However, this does not constitute a limitation on the embodiments of this application.

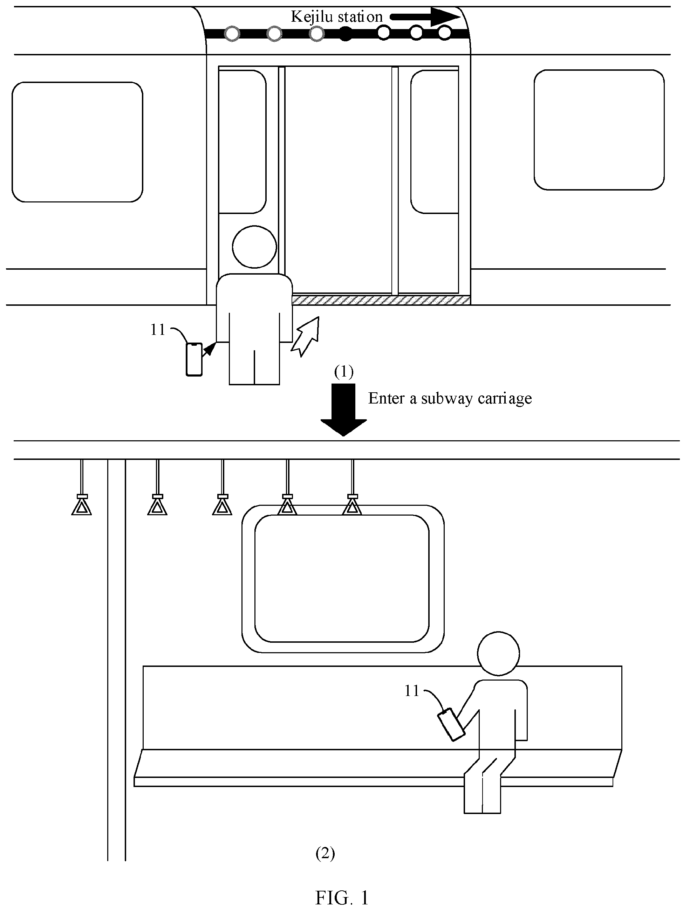

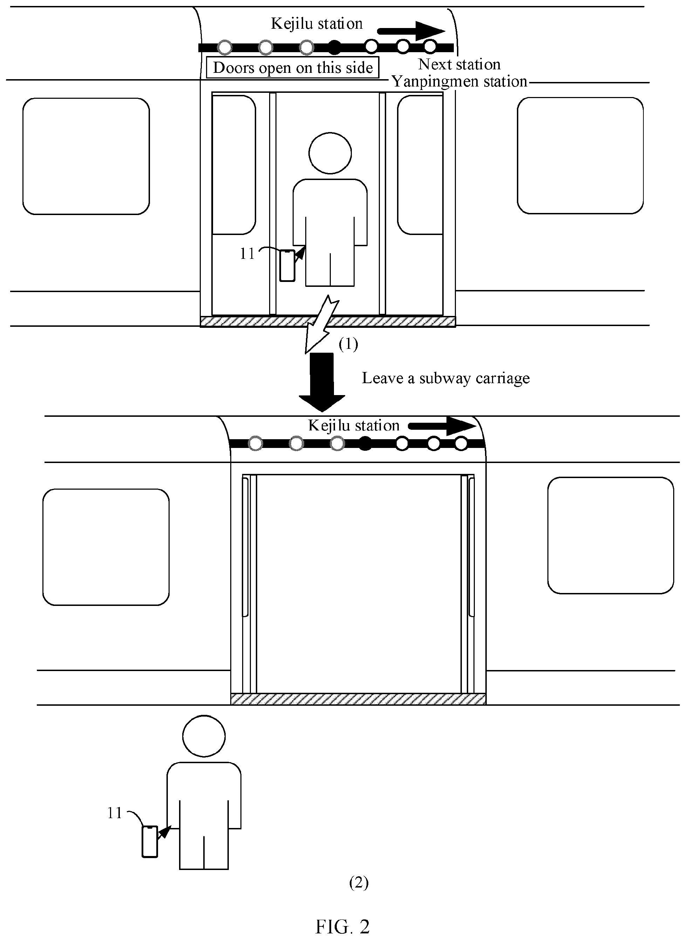

The technical solutions in the embodiments of this application are specific to a scenario in which a user gets on a subway carriage with an intelligent terminal and a scenario in which the user gets off the subway carriage with the intelligent terminal. Each of FIG. 1 and FIG. 2 is an example diagram of an application scenario according to an embodiment of this application.

An example diagram of a scenario in which a user gets on a subway carriage with a terminal is shown in (1) in FIG. 1 and (2) in FIG. 1. As shown in (1) in FIG. 1, a door of the subway carriage is opening, and the user is ready to enter the subway carriage with the terminal 11. As shown in (2) in FIG. 1, after entering the subway carriage, the user may use the terminal 11.

It should be understood that a scenario that is shown in (2) in FIG. 1 and in which the user uses the terminal 11 in a subway is merely an example for description. The embodiments of this application are not limited thereto. Actually, the user may not use the terminal 11 after entering the subway.

An example diagram of a scenario in which a user gets off a subway carriage with a terminal is shown in (1) in FIG. 2 and (2) in FIG. 2. As shown in (1) in FIG. 2, a door of the subway carriage is opening, and the user is ready to leave the subway carriage with the terminal 11. As shown in (2) in FIG. 2, the user has left the subway carriage with the terminal 11.

It should be understood that the scenarios in FIG. 1 and FIG. 2 are merely examples for describing an application scenario of this application. This does not constitute a limitation on the embodiments of this application, and this application is not limited thereto.

In the embodiments of this application, an example in which a user takes a subway is used for description. When the user takes the subway, if it cannot be effectively identified whether a terminal is in a state of getting on a subway or a state of getting off a subway, a personalized recommendation cannot be provided for the user or network optimization cannot be performed. Consequently, experience of using the terminal when the user takes the subway is affected.

According to the technical solutions provided in the embodiments of this application, acceleration data is collected by using an acceleration sensor, magnetometer data is collected based on a magnetometer, then a state of getting on/off a subway by a terminal user is jointly determined with reference to the acceleration data and the magnetometer data, and when it is determined that the terminal is in the state of getting off a subway, a first interface is presented to the user, where the first interface includes a first pop-up window, and the first pop-up window is used to display a boarding code for exit. In this way, the state of getting on/off a subway by the terminal can be accurately identified, to provide a recommended service for the user in a corresponding scenario.

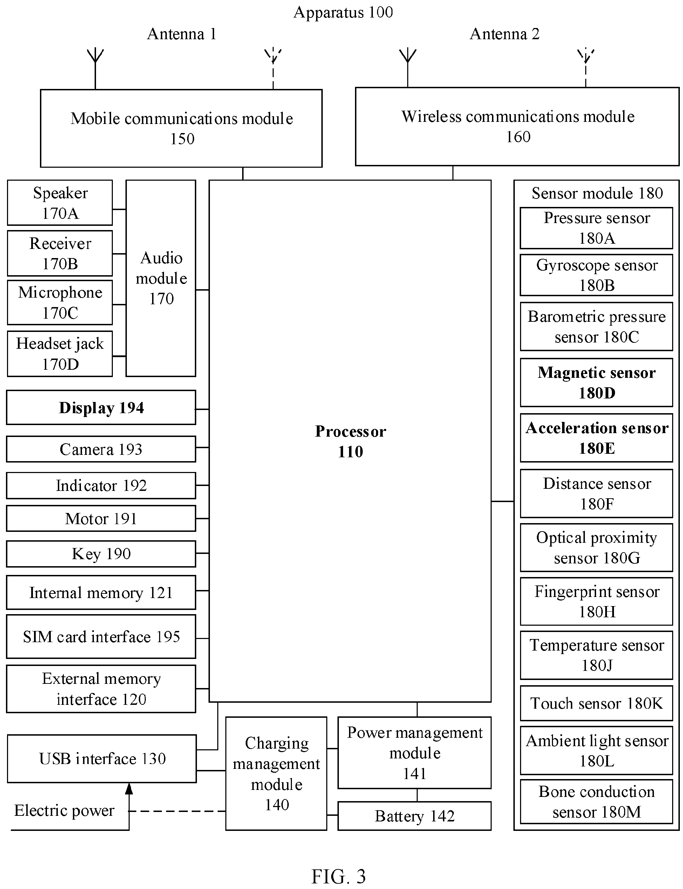

FIG. 3 shows a hardware system of an apparatus 100 applicable to this application.

The apparatus 100 may be an electronic device such as a terminal, a mobile phone, a smart screen, a tablet computer, a wearable electronic device, a vehicle-mounted electronic device, an augmented reality (augmented reality, AR) device, a virtual reality (virtual reality, VR) device, a notebook computer, an ultra-mobile personal computer (ultra-mobile personal computer, UMPC), a netbook, a personal digital assistant (personal digital assistant, PDA), or a projector. A specific type of the apparatus 100 is not limited in embodiments of this application.

The apparatus 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communications module 150, a wireless communications module 160, an audio module 170, a speaker 170A, a receiver 170B, a microphone 170C, a headset jack 170D, a sensor module 180, a key 190, a motor 191, an indicator 192, a camera 193, a display 194, a subscriber identification module (subscriber identification module, SIM) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It should be noted that a structure shown in FIG. 3 does not constitute a specific limitation on the apparatus 100. In some other embodiments of this application, the apparatus 100 may include more or fewer components than the components shown in FIG. 3, the apparatus 100 may include a combination of some of the components shown in FIG. 3, or the apparatus 100 may include subcomponents of some of the components shown in FIG. 3. For example, the optical proximity sensor 180G shown in FIG. 3 may be optional. The components shown in FIG. 3 may be implemented by hardware, software, or a combination of software and hardware.

The processor 110 may include one or more processing units. For example, the processor 110 may include at least one of the following processing units: an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and a neural-network processing unit (neural-network processing unit, NPU). Different processing units may be independent devices, or may be an integrated device.

The controller may generate an operation control signal based on instruction operation code and a timing signal, to control instruction fetching and instruction execution.

A memory may be further disposed in the processor 110, and is configured to store instructions and data. In some embodiments, the memory in the processor 110 is a cache. The memory may store instructions or data recently used or cyclically used by the processor 110. If the processor 110 needs to use the instructions or the data again, the processor 110 may directly invoke the instructions or the data from the memory. This avoids repeated access and reduces a waiting time of the processor 110, thereby improving system efficiency.

The connection relationship between the modules shown in FIG. 3 is merely an example for description, and does not constitute a limitation on the connection relationship between the modules in the apparatus 100. Optionally, the modules in the apparatus 100 may alternatively use a combination of a plurality of connection manners in the foregoing embodiment.

The apparatus 100 may implement a display function by using the GPU, the display 194, and the application processor. The GPU is a microprocessor for image processing and is connected to the display 194 and the application processor. The GPU is configured to perform mathematical and geometric calculation for graphics rendering. The processor 110 may include one or more GPUs, and the one or more GPUs execute program instructions to generate or change displayed information.

The display 194 may be configured to display an image or a video. The display 194 includes a display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flex light-emitting diode, FLED), a mini light-emitting diode (mini light-emitting diode, Mini LED), a micro light-emitting diode (micro light-emitting diode, Micro LED), a micro OLED (Micro OLED), or a quantum dot light emitting diode (quantum dot light emitting diodes, QLED). In some embodiments, the apparatus 100 may include one or N displays 194, where N is a positive integer greater than 1.

The apparatus 100 may implement a photographing function by using the ISP, the camera 193, the video codec, the GPU, the display 194, the application processor, and the like.

The ISP is configured to process data fed back by the camera 193. For example, during photographing, a shutter is pressed, light is transmitted to a photosensitive element of the camera through a lens, an optical signal is converted into an electrical signal, and the photosensitive element of the camera transmits the electrical signal to the ISP for processing, to convert the electrical signal into a visible image. The ISP may perform algorithm optimization on noise, brightness, and a color of an image, and the ISP may further optimize parameters such as exposure and a color temperature of a photographing scene. In some embodiments, the ISP may be disposed in the camera 193.

The camera 193 is configured to capture a still image or a video. An optical image is generated for an object through the lens and is projected onto the photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transmits the electrical signal to the ISP to convert the electrical signal into a digital image signal. The ISP outputs the digital image signal to the DSP for processing. The DSP converts the digital image signal into a standard image signal in a format such as red green blue (red green blue, RGB) or YUV. In some embodiments, the apparatus 100 may include one or N cameras 193, where N is a positive integer greater than 1.

The digital signal processor is configured to process a digital signal, and may process another digital signal in addition to the digital image signal. For example, when the apparatus 100 selects a frequency, the digital signal processor is configured to perform Fourier transform and the like on frequency energy.

The apparatus 100 may implement an audio function such as music playing and recording by using the audio module 170, the speaker 170A, the receiver 170B, the microphone 170C, the headset jack 170D, the application processor, and the like.

The audio module 170 is configured to convert digital audio information into an analog audio signal for output, and is further configured to convert an analog audio input into a digital audio signal. The audio module 170 may be further configured to encode and decode an audio signal. In some embodiments, the audio module 170 or some functional modules in the audio module 170 may be disposed in the processor 110.

The speaker 170A, also referred to as a loudspeaker, is configured to convert an audio electrical signal into a sound signal. The apparatus 100 may listen to music or listen to a hands-free call by using the speaker 170A.

The receiver 170B, also referred to as an earpiece, is configured to convert an audio electrical signal into a sound signal. When a user answers a call or listens to voice information by using the apparatus 100, the receiver 170B may be placed near an ear to listen to a voice.

The microphone 170C, also referred to as a mike or a mic, is configured to convert a sound signal into an electrical signal. When making a call or sending voice information, the user may make a sound near the microphone 170C to input a sound signal to the microphone 170C.

The headset jack 170D is configured to be connected to a wired headset. The headset jack 170D may be a USB interface 130, or may be a 3.5 mm open mobile apparatus 100 platform (open mobile terminal platform, OMTP) standard interface, or a cellular telecommunications industry association of the USA (cellular telecommunications industry association of the USA, CTIA) standard interface.

The gyroscope sensor 180B may be configured to determine a movement posture of the apparatus 100. In some embodiments, angular velocities of the apparatus 100 around three axes (namely, an x axis, a y axis, and a z axis) may be determined by using the gyroscope sensor 180B. The gyroscope sensor 180B may be configured to implement image stabilization during photographing. For example, when a shutter is pressed, the gyroscope sensor 180B detects a shake angle of the apparatus 100, and calculates, based on the angle, a distance that needs to be compensated by a lens module, so that the lens counteracts the shake of the apparatus 100 through a reverse movement, to implement image stabilization. The gyroscope sensor 180B may be further used in scenarios such as navigation and a motion sensing game.

The barometric pressure sensor 180C is configured to measure barometric pressure. In some embodiments, the apparatus 100 calculates an altitude based on a barometric pressure value that is measured by the barometric pressure sensor 180C, to assist in positioning and navigation.

The magnetic sensor 180D may include a Hall sensor. The apparatus 100 may detect opening and closing of a flip holster by using the magnetic sensor 180D. In some embodiments, when the apparatus 100 is a flip phone, the apparatus 100 may detect opening and closing of a flip cover based on the magnetic sensor 180D. The apparatus 100 may set a feature such as automatic unlocking of the flip cover based on a detected opening/closing state of the holster or a detected opening/closing state of the flip cover. Optionally, the magnetic sensor 180D may also be referred to as a magnetometer sensor. The magnetic sensor 180D is configured to collect magnetometer data of the apparatus 100. The magnetometer data reflects a magnetic field change around the electronic device.

The acceleration sensor 180E may detect magnitudes of acceleration of the apparatus 100 in all directions (usually, the x axis, the y axis, and the z axis). When the apparatus 100 is still, a magnitude and a direction of gravity may be detected. The acceleration sensor 180E may be further configured to identify a posture of the apparatus 100 as an input parameter of an application such as switching between a landscape mode and a portrait mode or a pedometer.

In some embodiments, acceleration information of the apparatus 100 may be obtained by using the acceleration sensor 180E.

The distance sensor 180F is configured to measure a distance. The apparatus 100 may measure a distance by using infrared or laser. In some embodiments, for example, in a photographing scene, the apparatus 100 may measure a distance by using the distance sensor 180F, to implement quick focusing.

The optical proximity sensor 180G may include, for example, a light-emitting diode (light-emitting diode, LED) and an optical detector such as a photodiode. The LED may be an infrared LED. The apparatus 100 emits infrared light outward by using the LED. The apparatus 100 detects infrared reflected light from a nearby object by using the photodiode. When the reflected light is detected, the apparatus 100 may determine that there is an object nearby. When no reflected light is detected, the apparatus 100 may determine that there is no object nearby. The apparatus 100 may detect, by using the optical proximity sensor 180G, whether the user holds the apparatus 100 close to the ear, to automatically turn off a screen to save power. The optical proximity sensor 180G may be further used for automatically unlocking and locking a screen in a holster mode or a pocket mode. It should be understood that the optical proximity sensor 180G in FIG. 3 may be an optional component. In some scenarios, an ultrasonic sensor may be used to replace the optical proximity sensor 180G to detect proximity light.

The ambient light sensor 180L is configured to sense brightness of ambient light. The apparatus 100 may adaptively adjust brightness of the display 194 based on the sensed brightness of the ambient light. The ambient light sensor 180L may be further configured to automatically adjust white balance during photographing. The ambient light sensor 180L may further cooperate with the optical proximity sensor 180G to detect whether the apparatus 100 is in a pocket to prevent an accidental touch. In some embodiments, ambient light information of the terminal may be detected by using the ambient light sensor 180L.

The fingerprint sensor 180H is configured to collect a fingerprint. The apparatus 100 may implement functions, such as unlocking, application lock accessing, photographing, and incoming call answering, by using a feature of the collected fingerprint.

The touch sensor 180K is also referred to as a touch device. The touch sensor 180K may be disposed on the display 194. The touch sensor 180K and the display 194 form a touchscreen, and the touchscreen is also referred to as a touch control screen. The touch sensor 180K is configured to detect a touch operation performed on or near the touch sensor 180K. The touch sensor 180K may transfer the detected touch operation to the application processor, to determine a touch event type. A visual output related to the touch operation may be provided by using the display 194. In some other embodiments, the touch sensor 180K may alternatively be disposed on a surface of the apparatus 100 at a location different from that of the display 194.

The key 190 includes a power key and a volume key. The key 190 may be a mechanical key, or may be a touch-sensitive key. The apparatus 100 may receive a key input signal, to implement a function that is related to a key input signal.

The motor 191 may generate a vibration. The motor 191 may be configured to provide an incoming call prompt, and may be further configured to provide touch feedback. The motor 191 may generate different vibration feedback effects for different touch operations performed on different applications. For touch operations performed on different areas of the display 194, the motor 191 may also generate different vibration feedback effects. Different application scenarios (for example, a time reminder, information receiving, an alarm clock, and a game) may correspond to different vibration feedback effects. A touch vibration feedback effect may be further customized.

In some embodiments, the processor 110 may obtain acceleration data of the terminal by using the acceleration sensor 180E; obtain magnetometer data of the terminal by using the magnetic sensor 180D; determine a first probability value based on the acceleration data and the magnetometer data, where the first probability value is used to represent a probability that the terminal is in a subway state, and when the first probability value is greater than a first probability threshold, the terminal is in the subway state; determine a state of a terminal user based on the first probability value, where the state of the terminal user includes a state of getting off a subway and a state of getting on a subway; and when determining that the terminal user is in the state of getting off a subway, display a first interface by using the display 194, where the first interface includes a first window, and the first window is used to display a travel card.

The hardware system of the apparatus 100 is described above in detail. The following describes a software system of the apparatus 100. The software system may use a layered architecture, an event-driven architecture, a microkernel architecture, a microservices architecture, or a cloud architecture. In the embodiments of this application, the layered architecture is used as an example to describe the software system of the apparatus 100.

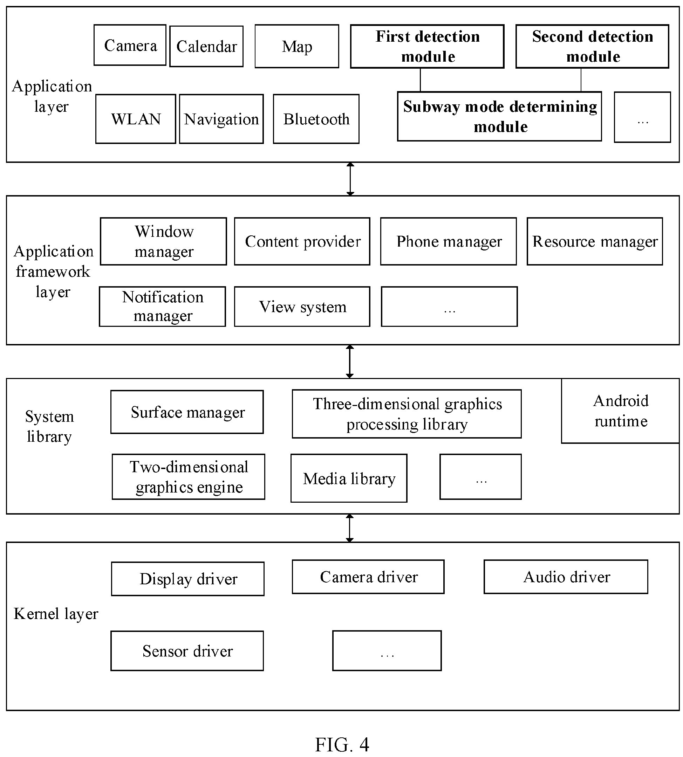

As shown in FIG. 4, a software system using a layered architecture is divided into several layers, and each layer has a clear role and task. Layers communicate with each other by using a software interface. In some embodiments, the software system may be divided into four layers: an application layer, an application framework layer, an Android runtime (Android Runtime) and system library, and a kernel layer from top to bottom.

The application layer may include applications such as Camera, Calendar, Phone, Map, Navigation, WLAN, and Bluetooth. It may be understood that the application shown in FIG. 4 is merely an example for description, and the embodiments of this application are not limited thereto. Optionally, the application layer may further include another system application (for example, Gallery, Music, Video, or Messages), a third-party program installed by a user, and the like.

In some possible embodiments, the application layer further includes a first detection module, a second detection module, and a subway mode determining module. The first detection module is configured to determine a first probability value based on acceleration data and magnetometer data. The first probability value is used to represent a probability that the terminal is in a subway state. When the first probability value is greater than a first probability threshold, the terminal is in the subway state. The second detection module is configured to determine a second probability value based on the acceleration data. The second probability value is used to represent a probability that the terminal is in a walking state. When the second probability value is greater than a second probability threshold, the terminal is in the walking state. The subway mode determining module is configured to determine, based on the first probability value, whether a terminal user is in a state of getting off a subway or a state of getting on a subway, or jointly determine, based on the first probability value and the second probability value, whether a terminal user is in a state of getting off a subway or a state of getting on a subway.

It should be understood that an example in which the first detection module, the second detection module, and the subway mode determining module are located at the application layer is used above for description. However, the embodiments of this application are not limited thereto. Actually, some or all of the first detection module, the second detection module, and the subway mode determining module may be located at another layer (for example, the system library) or the like.

The application framework layer provides an application programming interface (application programming interface, API) and a programming framework for the application at the application layer. The application framework layer may include some predefined functions.

For example, the application framework layer includes a window manager, a content provider, a view system, a phone manager, a resource manager, and a notification manager.

The window manager is configured to manage a window program. The window manager may obtain a display size, determine whether there is a status bar, perform screen locking, take a screenshot, and the like.

The content provider is configured to store and obtain data, and enable the data to be accessible to an application. The data may include a video, an image, audio, calls made and answered, a browsing history and a bookmark, and an address book.

The view system includes visual controls such as a text display control and a picture display control. The view system may be configured to construct an application. A display interface may include one or more views, for example, include a display interface of an SMS message notification icon, and may include a text display view and a picture display view.

The phone manager is configured to provide a communications function for the apparatus 100, for example, management of a call state (answering or declining).

The resource manager provides various resources for an application, such as a localized string, an icon, a picture, a layout file, and a video file.

The notification manager enables an application to display notification information in a status bar, and may be configured to convey a notification message that may automatically disappear after a short stay without requiring user interaction. For example, the notification manager is configured to provide a notification of download completion and a message notification. The notification manager may further manage a notification that appears in the status bar at the top of the system in a form of a graph or scroll bar text, for example, a notification of an application running in the background. The notification manager may further manage a notification that appears on a screen in a form of a dialog window. For example, text information is displayed in the status bar, a prompt tone is made, the electronic device vibrates, or an indicator light blinks.

The Android Runtime includes a kernel library and a virtual machine. The Android Runtime is responsible for scheduling and management of the Android system.

The kernel library includes two parts: One part is a functional function that needs to be invoked by a java language, and the other part is a kernel library of Android.

The application layer and the application framework layer are run in the virtual machine. The virtual machine executes java files at the application layer and the application framework layer as binary files. The virtual machine is configured to perform functions such as object lifecycle management, stack management, thread management, security and exception management, and garbage collection.

The system library may include a plurality of functional modules, for example, a surface manager (surface manager), a media library (Media Libraries), a three-dimensional graphics processing library (for example, an open graphics library for embedded systems (open graphics library for embedded systems, OpenGL ES)), and a 2D graphics engine (for example, a skia graphics library (skia graphics library, SGL)).

The surface manager is configured to manage a display subsystem and provide fusion of 2D and 3D layers for a plurality of applications.

The media library supports playback and recording of audio in a plurality of formats, playback and recording of videos in a plurality of formats, and still image files. The media library may support a plurality of audio and video coding formats, such as MPEG4, H.264, moving picture experts group audio layer III (moving picture experts group audio layer III, MP3), advanced audio coding (advanced audio coding, AAC), adaptive multi-rate (adaptive multi-rate, AMR), joint photographic experts group (joint photographic experts group, JPG), and portable network graphics (portable network graphics, PNG).

The three-dimensional graphics processing library may be configured to implement three-dimensional graphics drawing, image rendering, composition, and layer processing.

The two-dimensional graphics engine is a drawing engine for 2D drawing.

The kernel layer is a layer between hardware and software. The kernel layer may include drive modules such as a display driver, a camera driver, an audio driver, and a sensor driver.

The following describes an example of working procedures of the software system and the hardware system of the apparatus 100 with reference to display of a photographing scene.

When a user performs a touch operation on the touch sensor 180K, a corresponding hardware interrupt is sent to the kernel layer. The kernel layer processes the touch operation into an original input event. The original input event includes, for example, information such as touch coordinates and a timestamp of the touch operation. The original input event is stored at the kernel layer. The application framework layer obtains the original input event from the kernel layer, identifies a control corresponding to the original input event, and notifies an application (application, APP) corresponding to the control. For example, the touch operation is a tap operation, and the APP corresponding to the control is a camera APP. After the camera APP is awakened by the tap operation, the camera driver at the kernel layer may be invoked by using the API, and the camera 193 may be controlled by using the camera driver to perform photographing.

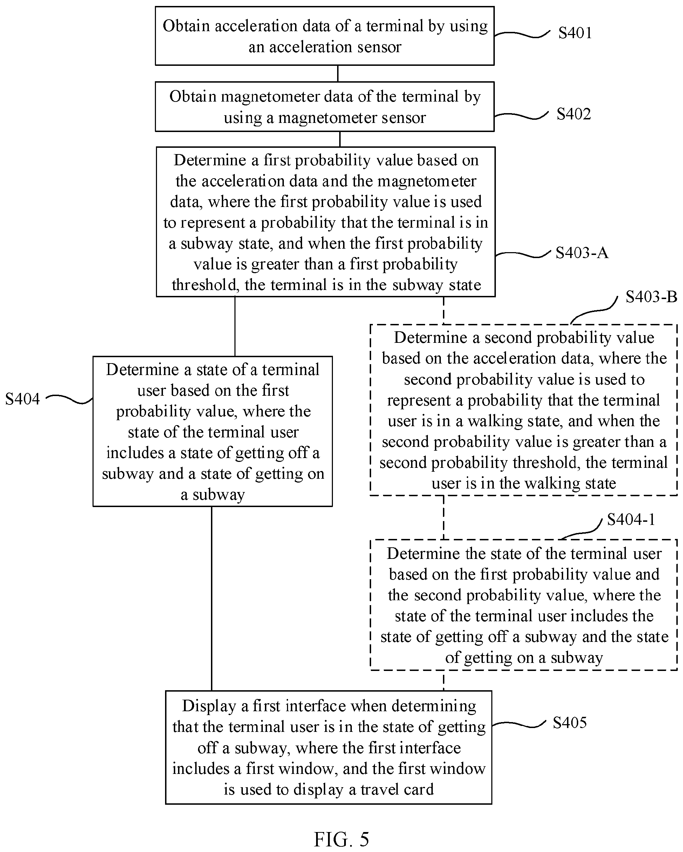

The following describes the terminal state identification method and apparatus according to the embodiments of this application with reference to FIG. 5 to FIG. 23.

FIG. 5 is a schematic flowchart of a terminal state identification method according to an embodiment of this application. It may be understood that an acceleration sensor in FIG. 5 is merely an example for description, and this application is not limited thereto. It may be understood that the sensor may be replaced with a sensor that has a same function. The method may be applied to the scenarios shown in FIG. 1 and FIG. 2. The method includes the following steps.

S401: Obtain acceleration data of a terminal by using the acceleration sensor.

Specifically, when a user takes a subway with the terminal, the acceleration data may be collected by using the acceleration sensor. For example, the acceleration data includes 3-axis (x axis, y axis, and z axis) data.

It may be understood that the acceleration sensor may be replaced with another sensor that can collect the acceleration data of the terminal.

For example, the acceleration sensor may be the acceleration sensor 180E in FIG. 3.

S402: Obtain magnetometer data of the terminal by using a magnetometer sensor.

The magnetometer data reflects a magnetic field change around the terminal. When the user takes a subway with the terminal, the magnetometer sensor may collect the magnetometer data of the terminal in real time.

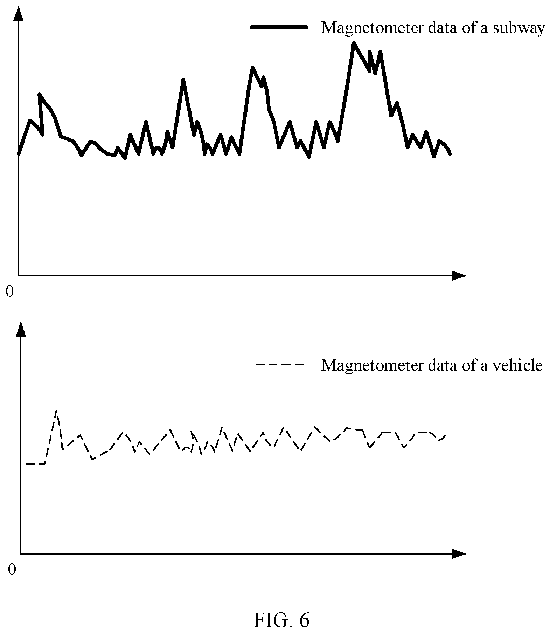

Generally, a high voltage is applied to a subway track. Therefore, for the subway, after the terminal is located in a subway carriage, a fluctuation change of the magnetometer data is greater than that of another means of transportation. For example, FIG. 6 is a diagram of comparison between magnetometer data of a vehicle and magnetometer data of a subway. It may be learned from FIG. 6 that a fluctuation of the magnetometer data of the subway is significantly greater than a fluctuation of the magnetometer data of the vehicle. Therefore, in this embodiment of this application, the magnetometer data of the terminal is collected to identify whether the terminal is in a subway state. That the terminal is in a subway state means that the terminal is located in a subway carriage, for example, the user carries the terminal and is located in a subway carriage.

It may be understood that the magnetometer data may also be referred to as another description such as a magnetometer signal, magnetometer information, magnetic field data, or a magnetic field signal. This is not specifically limited in this embodiment of this application.

S403-A: Determine a first probability value based on the acceleration data and the magnetometer data, where the first probability value is used to represent a probability that the terminal is in the subway state, and when the first probability value is greater than a first probability threshold, the terminal is in the subway state.

The first probability value may also be expressed as a subway probability value. The first probability value is used to represent a probability that the terminal is currently in the subway carriage.

Optionally, whether the terminal is in the subway state may be determined by setting the first probability threshold. If the calculated first probability value is greater than the first probability threshold, it is determined that the terminal is in the subway state.

The first probability threshold may be preset. A value of the first probability threshold is not limited in this embodiment of this application.

In this embodiment of this application, the subway probability value may be calculated by using a binary classification network. Optionally, in an embodiment, S403-A includes: inputting the acceleration data and the magnetometer data to a first binary classification network to obtain the first probability value.

The first binary classification network is a pre-trained network, and the collected acceleration data and magnetometer data are input to the first binary classification network, to output the first probability value.

A training process of the first binary classification network is not specifically limited in this embodiment of this application. For example, training data may be input to a decision tree network, and a parameter of a training model is continuously adjusted through iterative optimization until the training model is stable. After the model is stable, the trained model is used as the first binary classification network.

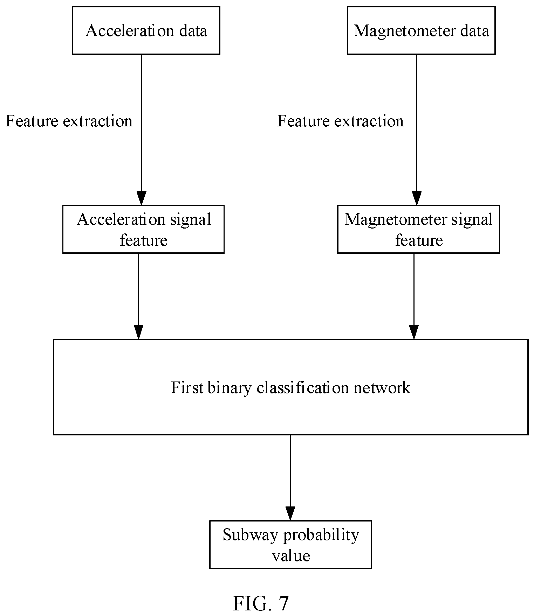

A flowchart in FIG. 7 is used as an example for description. As shown in FIG. 7, a process of calculating the first probability value may include the following steps: Feature extraction is performed based on the acceleration data, to obtain an acceleration signal feature; feature extraction is performed based on the magnetometer data, to obtain a magnetometer signal feature; the acceleration signal feature is input to the first binary classification network; and the subway probability value (namely, the first probability value) is obtained.

For example, that feature extraction is performed based on the acceleration data, to obtain an acceleration signal feature includes: The 3-axis data collected by the acceleration sensor is fused; and then the acceleration signal feature is extracted. For example, a time domain feature is obtained by calculating a mean variance and the like of fused 3-axis data, and a frequency domain feature is obtained in a manner such as Fourier transform or wavelet transform.

It should be understood that a person skilled in the art may learn that there are a plurality of means for feature extraction. This is merely an example for description. This embodiment of this application is not limited thereto.

It should be further understood that only a feature extraction process of the acceleration data is used an example for description herein. For feature extraction of the magnetometer data, refer to the descriptions herein.

A type of the binary classification network (including the first binary classification network and a second binary classification network that appears below) is not limited in this embodiment of this application. For example, the binary classification network may be a learning network such as a decision tree network, a support vector machines (support vector machines, SVM) network, a logistic regression network, or a neural network.

S404: Determine a state of a terminal user based on the first probability value, where the state of the terminal user includes a state of getting off a subway and a state of getting on a subway.

It should be noted that the state of the terminal user in this embodiment of this application is a state of getting on/off a subway carriage, and is not a state of entering/exiting a subway station. Specifically, the state of getting off a subway is a state of getting off a subway carriage by the user with the terminal, and the state of getting on a subway is a state of getting on a subway carriage by the user with the terminal.

In this embodiment of this application, the state of the terminal user may be determined based on the first probability value. Specifically, the state of the terminal user is determined based on the first probability value in the following two manners.

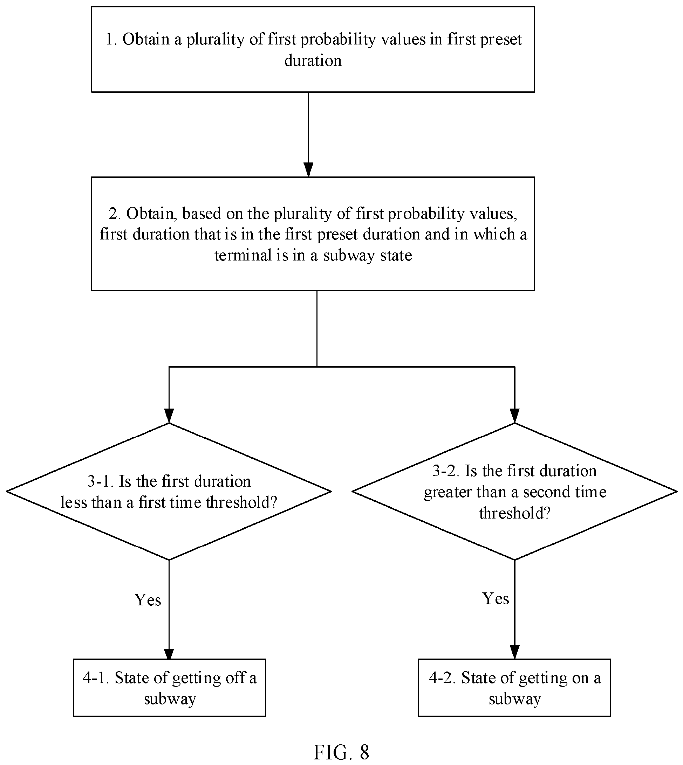

Manner 1: Optionally, in a possible implementation, the determining a state of a terminal user based on the first probability value may include step 1, step 2, step 3-1, and step 4-1 in FIG. 8. Specific steps are as follows:
Step 1: Obtain a plurality of first probability values in first preset duration.
Step 2: Obtain, based on the plurality of first probability values, first duration that is in the first preset duration and in which the terminal is in the subway state.
Step 3-1: Determine whether the first duration is less than a first time threshold.
Step 4-1: When the first duration is less than the first time threshold, determine that the terminal user is in the state of getting off a subway.

Specific duration of the first preset duration is not limited in this embodiment of this application. For example, the first preset duration may be set to 60 seconds.

As described above, when the first probability value is greater than the first probability threshold, the terminal may be defined as being in the subway state. Herein, accumulated duration (corresponding to the first duration) that is in a recent period of time (corresponding to the first preset duration) and in which the terminal is in the subway state needs to be counted, and then the accumulated duration is compared with a specified threshold (corresponding to the first time threshold). If the accumulated duration is less than the specified threshold, it is determined that the terminal user is in the state of getting off a subway.

It should be noted that the first duration may be duration including consecutive time points in the first preset duration, or may be duration including inconsecutive time points in the first preset duration. For example, the first duration includes the 30th second, the 33rd second, the 34th second, and the 36th second in the first preset duration. For another example, the first duration includes the 45th second to the 50th second in the first preset duration.

For example, if the first time threshold is 5 seconds, the first preset duration is 60 seconds, and in the 60 seconds, the accumulated duration in which the terminal is in the subway state is counted as 4 seconds, it may be learned that the 4 seconds is less than the 5 seconds. In this case, it is determined that the terminal user is in the state of getting off a subway.

Therefore, in the manner 1, based on the first probability value, by determining a relationship between the first duration and the first time threshold, it may be quickly determined that the terminal user is in the state of getting off a subway.

Manner 2: Optionally, in a possible implementation, the determining a state of a terminal user based on the first probability value may include step 1, step 2, step 3-2, and step 4-2 in FIG. 8. Specific steps are as follows:
For a manner of determining the first duration in the manner 2 and related descriptions, refer to descriptions of step 1 and step 2 in the manner 1. Details are not described herein again.

Step 3-2: Determine whether the first duration is greater than a second time threshold.

Step 4-2: When the first duration is greater than the second time threshold, determine that the terminal user is in the state of getting on a subway.

Similarly, herein, accumulated duration that is in the first preset duration and in which the terminal is in the subway state needs to be counted, and then the accumulated duration is compared with a specified threshold (the second time threshold). If the accumulated duration is greater than the specified threshold, it is determined that the terminal user is in the state of getting on a subway (for example, the scenario shown in FIG. 1).

For example, an application scenario for the manner 2 may be a scenario in which after getting off a subway, the terminal user transfers to a subway and gets on the new subway. In this case, walking duration (for example, walking duration less than 10 minutes) of entering a subway station may not be counted. Therefore, only the first probability value is considered.

Optionally, the first time threshold and the second time threshold may be the same or different. This is not limited in this embodiment of this application.

Optionally, the second time threshold may be greater than or equal to the first time threshold.

For example, if the second time threshold is 10 seconds, the first preset duration is 60 seconds, and in the 60 seconds, the accumulated duration in which the terminal is in the subway state is greater than 10 seconds, it is determined that the terminal user is in the state of getting on a subway.

Therefore, in the manner 2, based on the first probability value, by determining a relationship between the first duration and the second time threshold, it may be quickly determined that the user is in the state of getting on a subway.

It should be understood that the comparison relationship between the duration and the time threshold is merely an example for description, and this embodiment of this application is not limited thereto. For example, "the first duration is greater than the second time threshold" may be replaced with "the first duration is greater than or equal to the second time threshold". For another example, "the first duration is greater than the second time threshold" may be replaced with "the first duration falls within a preset time period".

In this embodiment of this application, if it is determined that the terminal user is in the state of getting off a subway carriage (for example, the scenario shown in FIG. 2), after the user leaves the subway carriage, an exit card may be presented to the user (or a subway boarding code is pushed in real time), to help the user swipe the card to exit the station.

S405: Display a first interface when determining that the terminal user is in the state of getting off a subway, where the first interface includes a first window, and the first window is used to display a travel card.

The travel card is a functional card used to enter and exit the subway station. An exit code to be used for the subway station may be displayed in the travel card, to help the user swipe the card to exit the station. This saves a time for the user to open the travel card.

It should be understood that a name of the travel card is not specifically limited in this embodiment of this application.

The type of the travel card is not specifically limited in this embodiment of this application. In addition, an application APP of the travel card is not limited in this embodiment of this application, and may be an APP that comes with a system, or may be a third-party APP.

The first interface may be a lock screen main interface, or may be an unlocked interface. This is not specifically limited in this embodiment of this application.

In an implementation, when the user is using the mobile phone, the first interface is an interface displayed when the user is currently using the mobile phone. The travel card (or the first window) may pop up from an upper part of a screen (for example, pop up in a notification bar).

In an implementation, if the terminal is in a screen-locked state, the screen is automatically turned on, and the travel card pops up in a lock screen interface.

Optionally, the travel card includes a two-dimensional code for card swiping to exit the station. For example, the travel card may be an exit card in third-party WeChat transport or an exit card in Alipay.

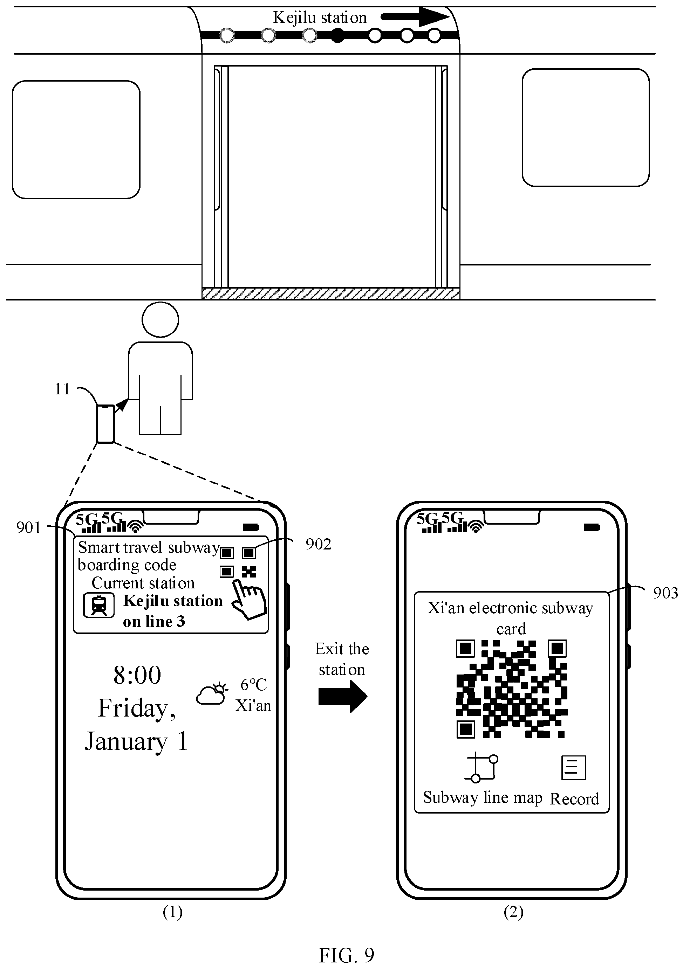

For example, the exit card may be a smart travel card that comes with the terminal. The smart travel card may include a boarding code for exit, for example, a two-dimensional code. FIG. 9 is a schematic diagram of an interface of the terminal presented after the user gets off the subway carriage. If the user gets off at Kejilu station, after it is identified that the user leaves the subway carriage with the term 11, the first interface may be displayed as an interface shown in (1) in FIG. 9. As shown in (1) in FIG. 9, a travel card 901 may automatically pop up in the mobile phone interface. The travel card includes a smart travel subway boarding code. For example, the travel card includes a thumbnail 902 of the boarding code. Optionally, a current subway station, for example, Kejilu station, may be displayed in the travel card 901.

It should be understood that the travel card 901 in FIG. 9 may be another type of travel card, for example, a travel card in Alipay or a travel card in WeChat. A type of the card that pops up herein may depend on a card type of a card that is swiped by the user to enter the station. The example in FIG. 9 is merely described by using an example in which the smart travel card is used by the user to enter the station. For example, if the user uses the travel card in Alipay to enter the station, the travel card in Alipay pops up herein; or if the user uses the travel card in WeChat to enter the station, the travel card in WeChat pops up herein.

It should be further understood that a location of the travel card 901 existing after the travel card 901 pops up is not limited in this embodiment of this application. The travel card 901 may be located in the middle of the screen, may be located at an upper part of the screen, or the like. A location of the travel card 901 shown in (1) in FIG. 9 does not constitute a limitation on this embodiment of this application.

It should be further understood that in (1) in FIG. 9, an example in which the mobile phone is in an unlocked state is used for description. However, this embodiment of this application is not limited thereto. If the user does not use the mobile phone after getting off the subway carriage, or the mobile phone is in the screen-locked state, the terminal may automatically turn on the screen, and the travel card 901 pops up in the lock screen interface.

When the user needs to swipe the boarding code to exit the station, the user may tap the thumbnail 902 of the boarding code, to enlarge the two-dimensional code for display, and a window 903 shown in (2) in FIG. 9 is displayed in the interface. In the interface shown in (2) in FIG. 9, the window 903 includes a two-dimensional code displayed in a large picture, to help the user swipe the card to exit the station.

Optionally, the window 903 may further include other controls, for example, a record control and a subway line map control. If the user taps the record control, a historical record may be viewed. If the user taps the subway line map, subway line maps in a city in which the user is located may be viewed.

It should be understood that the interface in FIG. 9 is merely an example for description, and does not constitute a limitation on the protection scope of the embodiments of this application.

Optionally, the travel card may further include a health code control. After the user taps the health code control, the terminal may display personal health code information of the user. In this way, if the user wants to enter a public place (for example, a shopping mall or a hotel) after exiting the subway station, the user may directly open the health code in the travel card, to provide convenience for the user.

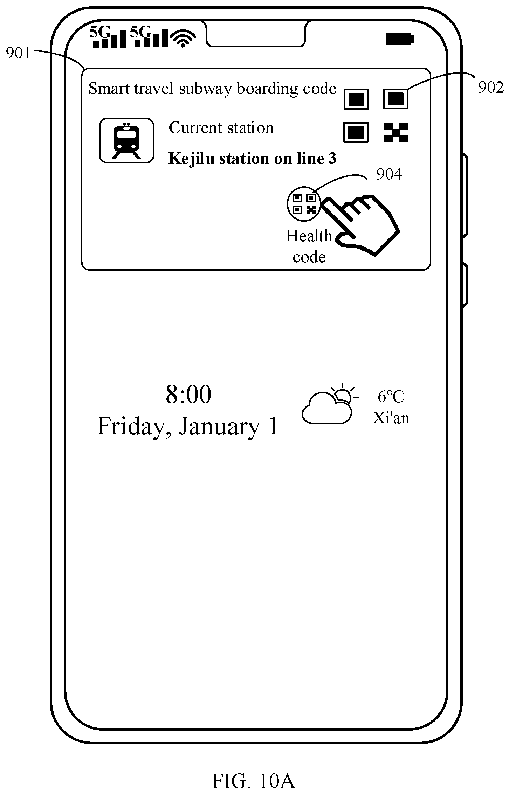

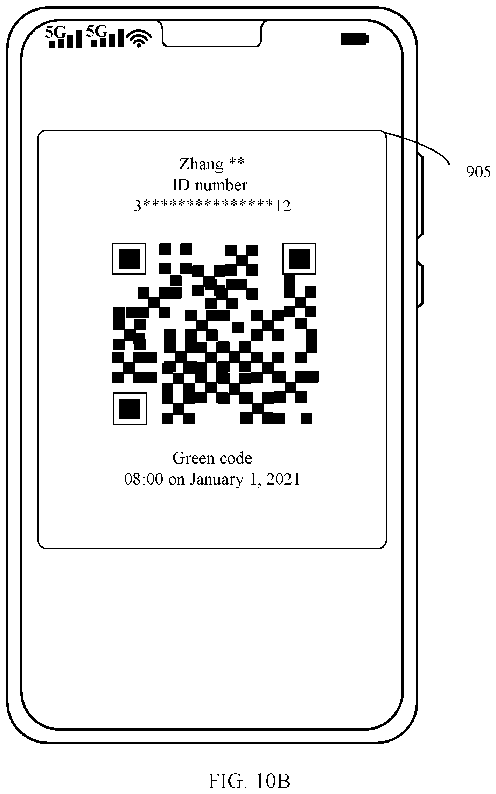

FIG. 10A and FIG. 10B are a schematic diagram of another interface of the terminal presented after the user gets off the subway carriage. If the user gets off at Kejilu station, after it is identified that the user leaves the subway carriage, the first interface may be displayed as an interface shown in FIG. 10A. As shown in FIG. 10A, a travel card 901 may automatically pop up in the mobile phone interface. The travel card 901 includes not only a thumbnail control 902 of a boarding code, but also a health code control 904. If the user taps the control 904, an interface shown in FIG. 10B is displayed. In an example, as shown in FIG. 10B, a window 905 is displayed in the mobile phone interface. The window 905 is configured to display the personal health code of and other information about the terminal user. For example, a type of the health code is a green code, and a specific current real-time time for displaying the health code (for example, an update time, that is, 8:00 on January 1, 2021, shown in FIG. 10B), and desensitized personal information (an identity card number, a name, and the like) of the user are displayed.

It may be understood that for other related descriptions of the travel card 901 and descriptions of the control 902, refer to the example in FIG. 9. Details are not described herein again.

It may be further understood that the window 905 shown in FIG. 10B is merely an example for description, and this embodiment of this application is not limited thereto. For example, the window 905 may further include other information or controls. Specific content may depend on a design of a health code application used in a city in which the terminal is currently located.

It may be further understood that the window 905 in FIG. 10B is merely an interface example, and specific display should be subject to actual information about the user.

It should be understood that the health code may have another name. This is not specifically limited. For example, the health code may also be referred to as an electronic code, a health kit, or a passing code.

Optionally, the travel card may further include an itinerary code control. After the user taps the itinerary code control, the terminal may display personal itinerary information of the user. In this way, if the user is to enter a public place (for example, a shopping mall or a hotel) after exiting the subway station, and an itinerary code needs to be viewed, the itinerary code may be directly opened in the travel card, to provide convenience for the user.

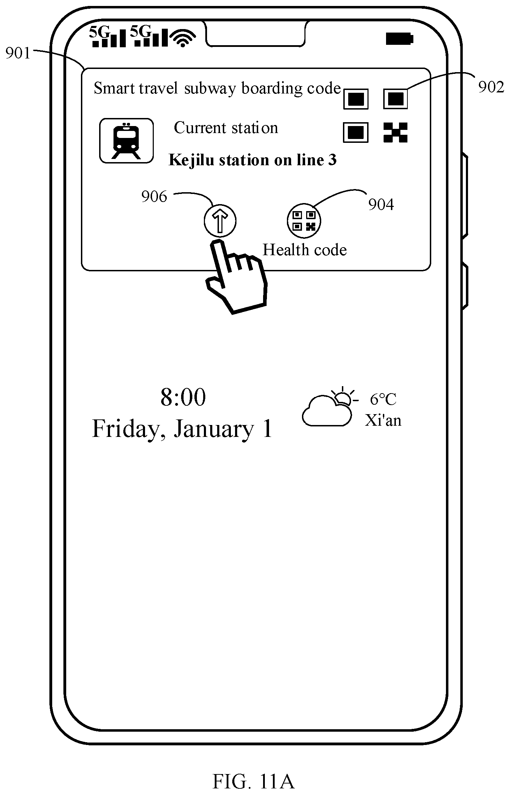

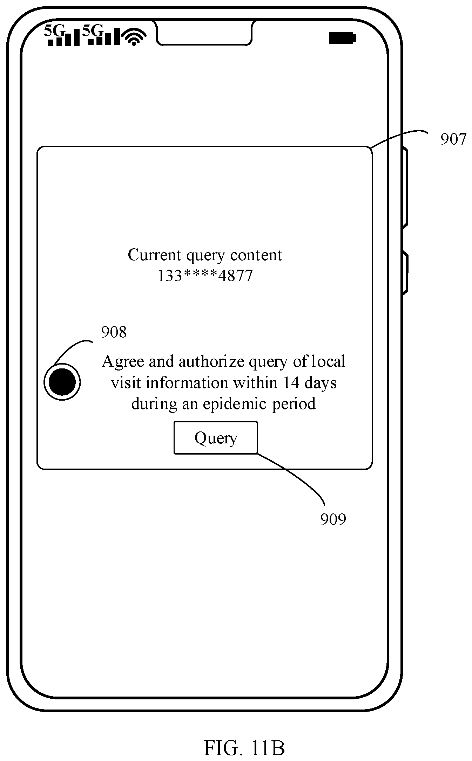

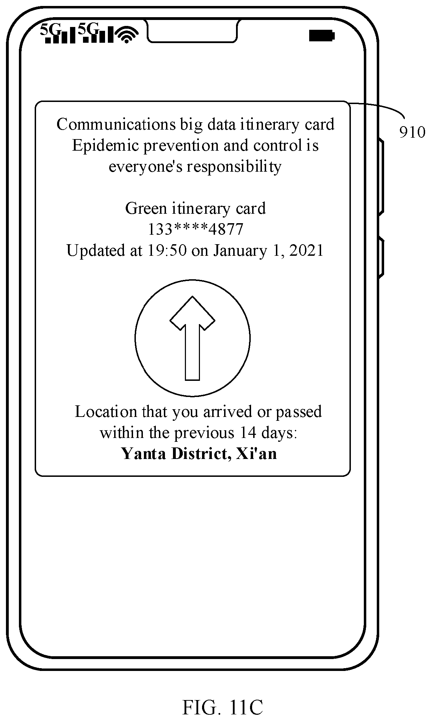

FIG. 11A, FIG. 11B, and FIG. 11C are a schematic diagram of still another interface of the terminal presented after the user gets off the subway carriage. For example, if the user gets off at Kejilu station, after it is identified that the user leaves the subway carriage, the first interface may be displayed as an interface shown in FIG. 11A. As shown in FIG. 11A, a travel card 901 may automatically pop up in the mobile phone interface. The travel card 901 includes a thumbnail control 902 (for a specific function, refer to the descriptions in FIG. 9) of a boarding code, a health code control 904 (for a specific function, refer to the descriptions in FIG. 10A and FIG. 10B), and an itinerary card control 906.

If the user taps the control 906, an interface shown in FIG. 11B is displayed. In the interface shown in FIG. 11B, the mobile phone displays a window 907. The window 907 includes a control 909 for querying an itinerary card and an authorization agreement option 908. If the user agrees and authorizes query of local visit information within 14 days during an epidemic period, the authorization agreement option 908 may be tapped. When the user selects to agree and authorize query of the local visit information within the 14 days during the epidemic period, the control 909 may be tapped to query itinerary information.

In an example, after the user taps the control 909, the mobile phone interface may be displayed as an interface shown in FIG. 11C. As shown in FIG. 11C, a window 910 is displayed in the mobile phone interface. The window 910 is configured to display personal itinerary card information of and other information about the terminal user. For example, a location (Yanta District, Xi'an) that the user arrived or passed within the previous 14 days, a green communications itinerary card, a current real-time time for displaying the itinerary card, and desensitized personal information (a phone number and the like) of the user are displayed in the window 910.

It may be understood that for other related descriptions of the travel card 901 and descriptions of the control 902, refer to the example in FIG. 9. Details are not described herein again.

It may be further understood that for descriptions of the health code control 904 included in the travel card 901, refer to the example in FIG. 10A and FIG. 10B. Details are not described herein again.

It may be further understood that the interface in FIG. 11C is merely an example, and specific display should be subject to actual information about the user.

A location of the itinerary code control is not specifically limited in this embodiment of this application. In an implementation, as shown in FIG. 11A, the itinerary code control may be located in the travel card 901. In another implementation, the itinerary code control may be located in the window 905 shown in FIG. 10B. That is, after displaying the health code by using the window 905, the user may continue to tap the itinerary code control in the window 905, to display itinerary code information. After the itinerary code control is tapped, subsequent operations or interfaces may be the same as the interfaces shown in FIG. 11B and FIG. 11C.

Generally, after the user gets off the subway carriage, there are two possibilities: exiting the station and making an intra-station transfer. Regardless of whether the user is to exit the station or make an intra-station transfer, in this embodiment of this application, the state of the terminal user may be intelligently identified. If the terminal user is to exit the station after getting off the subway carriage, the boarding code (as shown in the interface shown in FIG. 9) may be tapped to exit the station. If the terminal user needs to transfer to another subway station after getting off the subway carriage, the terminal may continuously turn on the screen and display the travel card until it is detected that the terminal user is in the state of getting on a subway. In this case, the travel card automatically disappears.

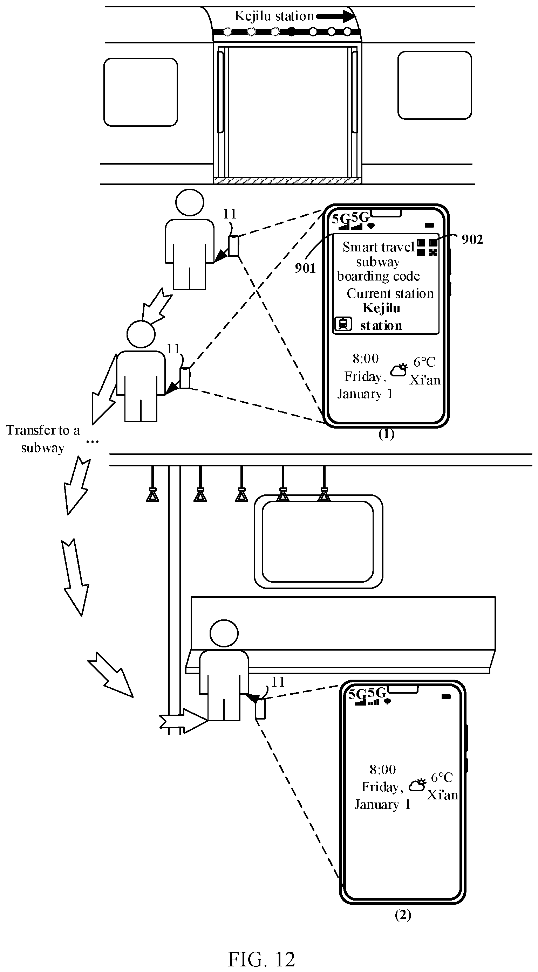

FIG. 12 is an example diagram of an interface of the mobile phone presented when the user transfers to a subway. After the user gets off the subway carriage, the mobile phone interface may be displayed as shown in (1) in FIG. 12, that is, a travel card 901 pops up. The travel card 901 includes a two-dimensional code thumbnail 902. For descriptions of the travel card 901 and the two-dimensional code thumbnail 902, refer to the descriptions in FIG. 9. Details are not described herein again. After getting off the subway carriage, the user continues to walk, and prepares to transfer to another subway line. When the user transfers to the subway line, if it is identified that the user enters a subway carriage again, the travel card 901 may automatically disappear. For example, as shown in (2) in FIG. 12, the mobile phone may display a current main interface. Alternatively, if it is identified that the user enters the subway carriage again, the screen of the mobile phone is directly turned off. It may be understood that the interface shown in (2) in FIG. 12 is merely an example for description, and this embodiment of this application is not limited thereto.

In an implementation, if the user is using the mobile phone, the travel card 901 may automatically disappear after it is identified that the user enters the subway carriage again; or if the user does not use the mobile phone, after it is identified that the user enters the subway carriage again, the mobile phone enters a screen-off state, that is, the travel card 901 disappears accordingly.

Optionally, after it is identified that the user enters the subway carriage, a related interface presented after the subway carriage is entered may automatically pop up. The related interface is described below when an embodiment in which it is identified that the user is in the state of getting on a subway is described.

In this embodiment of this application, the acceleration data and the magnetometer data are obtained, the first probability value is determined based on the acceleration data and the magnetometer data, then the state of getting on/off a subway by the terminal user is determined with reference to the first probability value, and finally a boarding code for exit is displayed to the user when the state of getting off a subway is determined. In this way, it can be accurately identified whether the user is in the state of getting off a subway, and when the state of getting off a subway is identified, a to-be-used exit card function pops up or is pushed for the user in real time. This saves a time for the user to actively open the exit card, and provides a convenient service for the user.

In addition, in this embodiment of this application, a walking probability value of the user may be further calculated, and then the walking probability value of the user is used as a factor for determining the state of getting on/off a subway by the terminal user. Specifically, both the subway probability value and the walking probability value may be considered to determine the state of getting on/off a subway by the terminal user. Detailed descriptions are provided below.

Optionally, in an embodiment, as shown in FIG. 5, the method further includes the following step:
S403-B: Determine a second probability value based on the acceleration data, where the second probability value is used to represent a probability that the terminal user is in a walking state, and when the second probability value is greater than a second probability threshold, the terminal user is in the walking state.

The walking state of the terminal user is a movement state in which the user walks with the terminal.

It should be understood that walking is an overview of a movement behavior scenario of the user, and walking includes but is not limited to behavior such as having a walk, running, or jumping.

In this embodiment of this application, the second probability value may be calculated by using a binary classification network. Optionally, in an embodiment, S403-B includes: inputting the acceleration data to the binary classification network to obtain the second probability value.

For example, the binary classification network is a pre-trained network, and the collected acceleration data is input to the binary classification network, to calculate the second probability value.

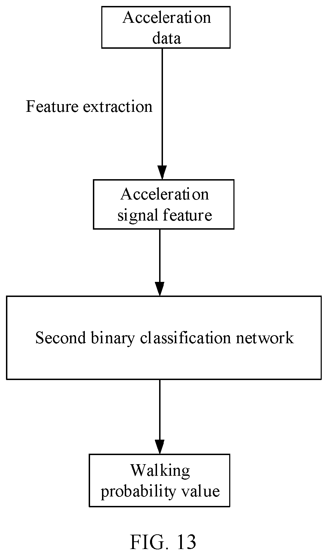

A flowchart in FIG. 13 is used as an example for description. As shown in FIG. 13, a process of calculating the second probability value may include the following steps: Feature extraction is performed based on the acceleration data, to obtain an acceleration signal feature; the acceleration signal feature is input to the second binary classification network; and the walking probability value (namely, the second probability value) is obtained.

It should be understood that the first binary classification network in FIG. 7 and the second binary classification network in FIG. 13 may be of different network types, or may be of a same network type. This is not specifically limited. For example, the first binary classification network in FIG. 7 is a decision tree network, and the second binary classification network in FIG. 13 is a binary classification neural network. For another example, both the first binary classification network in FIG. 7 and the second binary classification network in FIG. 13 are decision tree networks.

In this embodiment of this application, duration that is in preset duration and in which the terminal user is in the walking state is obtained, to determine the state of getting on/off a subway by the terminal user.

Optionally, S404 includes the following step: S404-1: Determine the state of the terminal user based on the first probability value and the second probability value, where the state of the terminal user includes the state of getting off a subway and the state of getting on a subway.

Specifically, the state of the terminal user may be jointly determined based on the first probability value and the second probability value in the following two manners:

### Manner 3

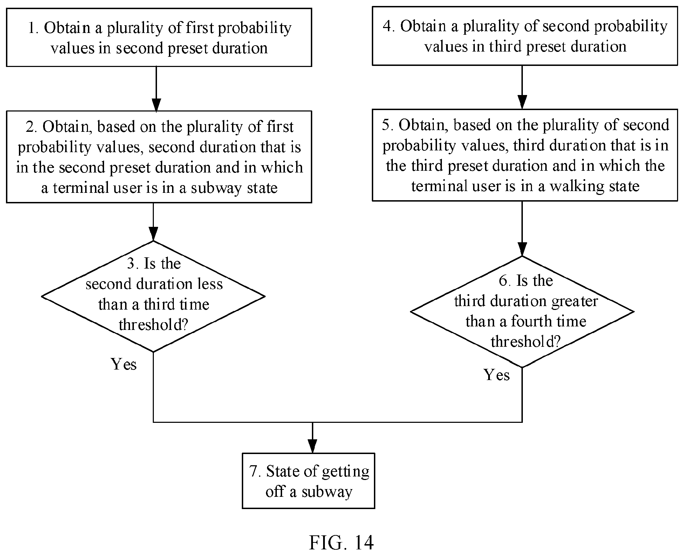

Optionally, in a possible implementation, the determining the state of the terminal user based on the first probability value and the second probability value may include steps shown in FIG. 14. As shown in FIG. 14, the following steps are included:
Step 1: Obtain a plurality of first probability values in second preset duration.
Step 2: Obtain, based on the plurality of first probability values, second duration that is in the second preset duration and in which the terminal user is in the subway state.
Step 3: Determine whether the second duration is less than a third time threshold.
Step 4: Obtain a plurality of second probability values in third preset duration.
Step 5: Obtain, based on the plurality of second probability values, third duration that is in the third preset duration and in which the terminal user is in the walking state.
Step 6: Determine whether the third duration is greater than a fourth time threshold.
Step 7: When the second duration is less than the third time threshold, and the third duration is greater than the fourth time threshold, determine that the terminal user is in the state of getting off a subway.

Values of the second preset duration and the third preset duration are not specifically limited in this embodiment of this application, and the second preset duration and the third preset duration may be the same or different. For example, the second preset duration is 10 seconds, and the third preset duration is 10 seconds. For another example, the second preset duration is 10 seconds, and the third preset duration is 15 seconds.

Specifically, in this manner, not only accumulated duration (corresponding to the second duration) that is in a recent period of time (corresponding to the second preset duration) and in which the terminal user is in the subway state needs to be counted, but also accumulated duration (corresponding to the third duration) that is in a recent period of time (corresponding to the third preset duration) and in which the terminal user is in the walking state needs to be counted, and then the counted accumulated duration is respectively compared with corresponding thresholds, that is, the second duration is compared with the third time threshold, and the third duration is compared with the fourth time threshold. When both the two segments of accumulated duration meet respective threshold conditions, for example, the second duration is less than the third time threshold, and the third duration is greater than the fourth time threshold, it may be determined that the terminal user is in the state of getting off a subway.

Similarly, the second duration (or the third duration) may be duration including consecutive time points, or may be duration including inconsecutive time points. For related specific example descriptions, refer to the descriptions of the first duration. For brevity, details are not described herein again.

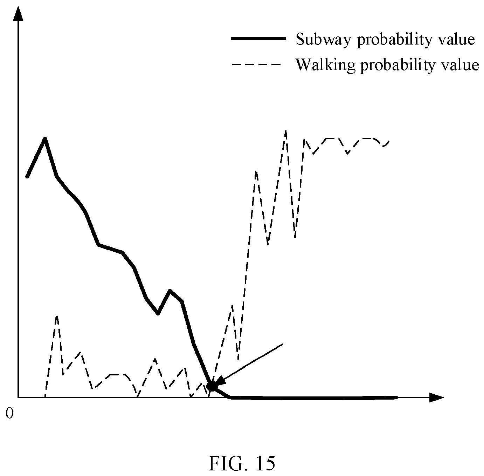

Generally, when the user leaves the subway carriage, there is a process in which the first probability value (or the subway probability value or a subway score value) decreases and the second probability value (or the walking probability value or a walking score value) increases. For example, FIG. 15 shows change trends of the first probability value and the second probability value when the user gets off the subway. As shown in FIG. 15, when the user gets off the subway, the subway probability value decreases continuously over time, and the walking score value increases accordingly. For example, a black dot shown in FIG. 15 may be determined as a time point at which the user gets off the subway carriage. It should be understood that the example in FIG. 15 is merely an example for description, and does not constitute a limitation on this embodiment of this application.

Therefore, in the manner 3, based on the first probability value and the second probability value, it is jointly determined that the terminal user is in the state of getting off a subway. This can improve determining accuracy.

### Manner 4

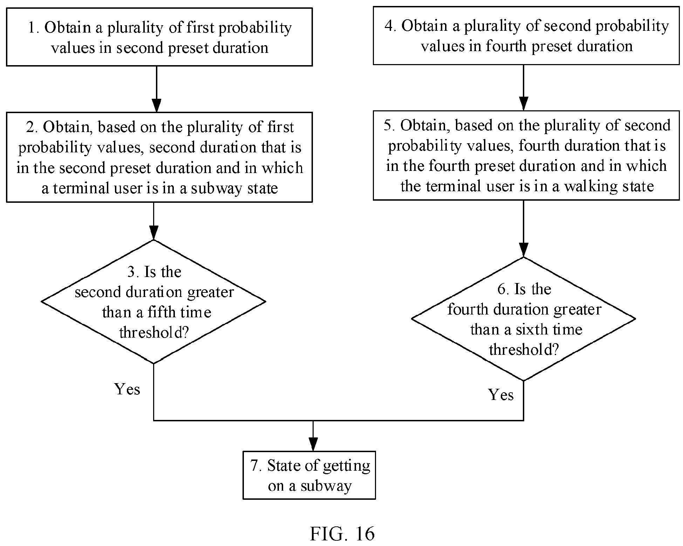

Optionally, in a possible implementation, the determining the state of the terminal user based on the first probability value and the second probability value may include steps shown in FIG. 16. As shown in FIG. 16, the following steps are included:
Step 1: Obtain a plurality of first probability values in second preset duration.
Step 2: Obtain, based on the plurality of first probability values, second duration that is in the second preset duration and in which the terminal user is in the subway state.
Step 3: Determine whether the second duration is greater than a fifth time threshold.
Step 4: Obtain a plurality of second probability values in fourth preset duration.
Step 5: Obtain, based on the plurality of second probability values, fourth duration that is in the fourth preset duration and in which the terminal user is in the walking state.
Step 6: Determine whether the fourth duration is greater than a sixth time threshold.
Step 7: When the fourth duration is greater than the sixth time threshold, and the second duration is greater than the fifth time threshold, determine that the terminal user is in the state of getting on a subway.

For descriptions of the second preset duration, refer to the foregoing descriptions. Details are not described herein again.

A value of the fourth preset duration is not specifically limited in this embodiment of this application. For example, the fourth preset duration is 10 minutes. A reason for introducing the fourth preset duration herein is to count accumulated duration that is in the fourth preset duration and in which the terminal user is in the walking state. Generally, the user usually has a walking time in a period of time (for example, 10 minutes) existing before the subway carriage is entered. Based on the walking time, it may be jointly determined whether the terminal user enters the subway carriage.

Specifically, in this manner, not only accumulated duration (corresponding to the second duration) that is in a recent period of time and in which the terminal user is in the subway state needs to be counted, but also accumulated duration (corresponding to the fourth duration) that is in a recent period of time (corresponding to the fourth preset duration) and in which the terminal user is in the walking state needs to be counted, and then the accumulated duration is respectively compared with corresponding thresholds, that is, the second duration is compared with the fifth time threshold, and the fourth duration is compared with the sixth time threshold. When both the two segments of accumulated duration meet respective threshold conditions, for example, the fourth duration is greater than the sixth time threshold, and the second duration is greater than the fifth time threshold, it may be determined that the terminal user is in the state of getting on a subway.

For example, an application scenario for the manner 4 may be a scenario in which the terminal user enters the subway station to take the subway for the first time. In this case, the user takes the subway for the first time, and there is not a subway transfer scenario. Therefore, a walking time existing before the subway is entered needs to be considered.

The manner 2 described above is also a method for determining that the terminal user is in the state of getting on a subway. A difference between the manner 2 and the manner 4 lies in that the second probability threshold does not need to be considered in the manner 2. This is because the manner 2 is applicable to a subway transfer scenario. For the subway transfer scenario, only the first probability value (namely, the subway probability value) needs to be considered.

Similarly, the second duration (or the fourth duration) in this manner may be duration including consecutive time points, or may be duration including inconsecutive time points. For related specific example descriptions, refer to the descriptions of the first duration. For brevity, details are not described herein again.

Therefore, in the manner 4, based on the first probability value and the second probability value, it is jointly determined that the terminal user is in the state of getting on a subway. This can improve determining accuracy.

When the state of getting on a subway is intelligently determined, this embodiment of this application further provides a network optimization function. After the subway carriage is entered, signal quality in the carriage is relatively poor. Therefore, when the state of getting on a subway is intelligently determined, a network acceleration module of the terminal may be turned on or enabled for the user, to accelerate a network connection or perform network optimization, and improve Internet access experience of the user in the subway carriage.

Optionally, in a possible implementation, the method further includes:
enabling the network acceleration module when determining that the state of the terminal user is the state of getting on a subway.

Optionally, the network acceleration module may be implemented through full network aggregation acceleration technology (Link Turbo) network optimization. A Link Turbo network optimization function means to bring mobile Internet access experience with a high network speed and a stable low delay to the user in a changing network condition through network technology innovation on a terminal side, combination of applications and network partners, and cloud-based collaborative network aggregation. That is, Link Turbo pre-predicts that the terminal enters a cellular network freeze circle, and performs network optimization by using the network acceleration module, to avoid impact on Internet access experience of the user. Network signal quality in the subway carriage is not stable enough. Therefore, Link Turbo is enabled to improve Internet access experience when the user takes the subway.

A specific occasion for enabling the network acceleration module is not limited in this embodiment of this application. In an implementation, the network acceleration module is automatically enabled provided that it is intelligently determined that the user is in the state of getting on a subway. In another implementation, before the network acceleration module is enabled, a screen-on state of the terminal may be determined first, and then whether the network acceleration module is enabled is determined based on the screen-on state. In still another implementation, before the network acceleration module is enabled, it may be further determined whether the user is using an APP, and then whether the network acceleration module is enabled is determined based on whether the user is using an APP. In still another implementation, after the subway carriage is entered for a period of time, if it is determined that the user turns on the mobile phone in the period of time, and the screen is continuously turned on for 10 seconds to 20 seconds, or an APP is opened, the network acceleration module is automatically enabled. The implementations are separately described below.

Optionally, in a possible implementation, before the enabling the network acceleration module, the method further includes:
determining whether the terminal is in the screen-on state; and
enabling the network acceleration module if the terminal is in the screen-on state; or
not enabling the network acceleration module if the terminal is not in the screen-on state.

Herein, whether the terminal is in the screen-on state may be determined after the state of getting on a subway is intelligently determined. If it is detected that the terminal is in the screen-on state, the user may be currently using the terminal. To improve experience of using the terminal in the subway (for example, optimizing a network and increasing an Internet access speed of the user), the network acceleration module may be enabled. If it is detected that the terminal is not in the screen-on state, it indicates that the user does not use the terminal. To reduce power consumption, the network acceleration module may not be enabled.

Optionally, in a possible implementation, after the enabling the network acceleration module, the method further includes:
displaying a prompt box to the user, where the prompt box includes a first option and a second option, the first option is used to choose to disable the network acceleration module, and the second option is used to choose to continue to enable the network acceleration module.

If the user taps the first option, the network acceleration module may be disabled, to avoid an increase in network traffic and reduce power consumption of the terminal. If the user taps the second option, a state of enabling the network acceleration module is maintained.

It may be understood that after the user selects the first option or the second option, the prompt box automatically disappears.

Optionally, if the user does not perform selection (for example, neither taps the first option nor taps the second option), it is considered, by default, that the network acceleration module of the terminal continues to be enabled. In addition, if the user does not perform selection after preset duration, the prompt box automatically disappears after staying for 5 seconds.

It may be understood that, that the prompt box automatically disappears means that the prompt box is not displayed in the interface and may be hidden in the notification bar. When the user needs to view the prompt box again, the prompt box may be found in a message list in the notification bar (for example, a drop-down notification bar). For example, if the user has not had time to perform selection after entering the subway carriage, the user performs an operation on the option in the prompt box when viewing a message in the notification bar after a period of time.

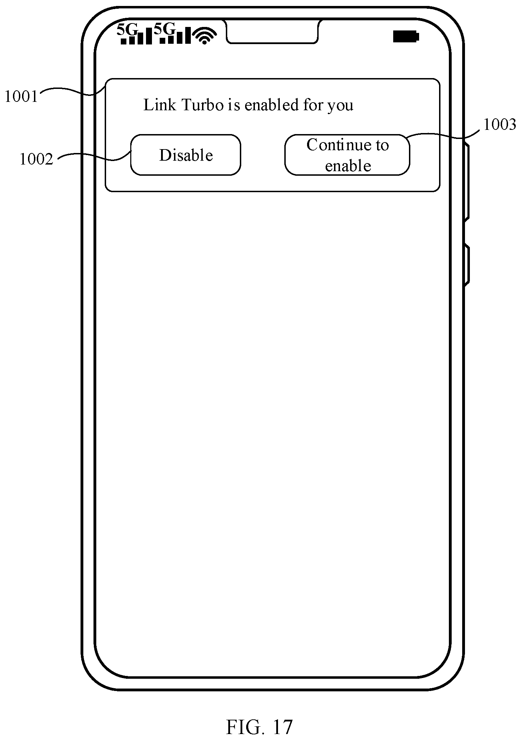

An example in which the network optimization module is implemented by using Link Turbo is used. In this case, after the state of getting on a subway is identified, the prompt box may pop up on the screen, as shown in an interface shown in FIG. 17. The interface includes a dialog box 1001, and the dialog box 1001 may be used to prompt the user that the Link Turbo function is enabled. Optionally, the dialog box 1001 includes a disable option 1002 and a continue to enable option 1003. If the user taps the disable option 1002, the Link Turbo function may be disabled. If the user taps the continue to enable option 1003, the Link Turbo function continues to be enabled.

It should be understood that a specific interface in which the dialog box 1001 is located is not limited in this embodiment of this application. For example, if the user does not use the terminal, the dialog box 1001 is displayed in the lock screen interface. For another example, if the user is using the terminal, the dialog box 1001 is displayed in the notification bar.

Optionally, in a possible implementation, before the enabling the network acceleration module, the method further includes:
detecting whether the user is currently using the mobile phone; and
enabling the network acceleration module when detecting that the user is using the mobile phone.

For example, in the subway carriage, the user needs to use the mobile phone while taking the subway. In this case, if it is detected that the terminal is in a screen-on state, the network acceleration module is enabled. If it is detected that the user does not use the mobile phone, the network acceleration module is not enabled.

A scenario in which the network acceleration module is not enabled is not specifically limited in this embodiment of this application. For example, after the mobile phone automatically enables the Link Turbo function, the user may choose to disable the Link Turbo function, for example, tap the disable option 1002 in FIG. 17. For another example, in a setting of smart travel, the user may choose to disable the Link Turbo function in the subway state by default.

This embodiment of this application further provides a setting option for a subway mode. In the setting option, the user may choose to enable or disable a network acceleration function by default.

Optionally, in a possible implementation, the method further includes:
displaying a first setting interface, where the first setting interface includes a subway setting control; and
entering a subway setting interface in response to an operation performed by the user on the subway setting control, where the subway setting interface includes a third option, and the third option is used to choose to enable or disable the network acceleration module in the subway state by default.

The user may preset, in the subway setting control, whether to enable the network acceleration module in the subway state by default. If the user sets that the network acceleration module in the subway state is enabled by default, the network acceleration module is automatically enabled after a subway scenario is intelligently identified (for example, the subway carriage is entered), to improve Internet access experience when the user takes the subway. If the user sets that the network acceleration module in the subway state is disabled by default, the network acceleration module is not automatically enabled even after a subway scenario is identified (for example, the subway carriage is entered), to reduce power consumption.

For example, the subway setting interface may include an on/off option indicating whether to enable Link Turbo by default.

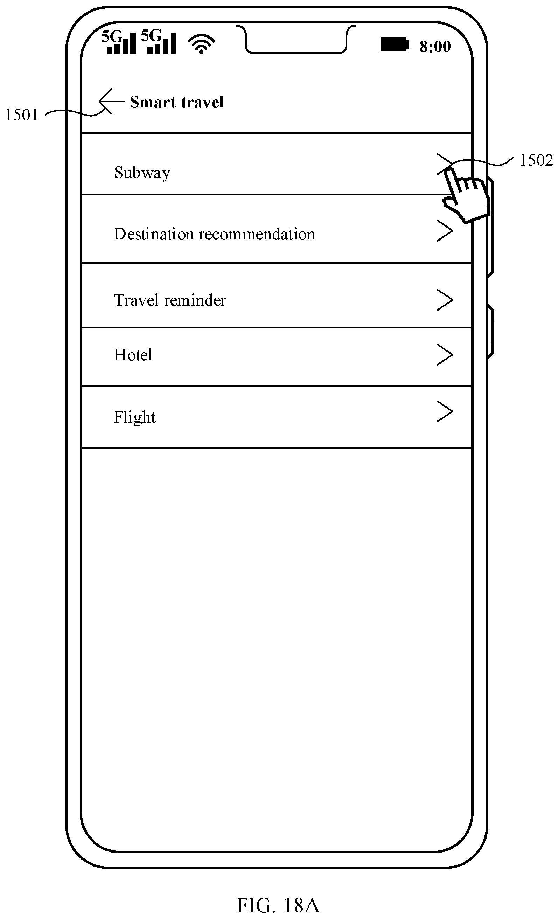

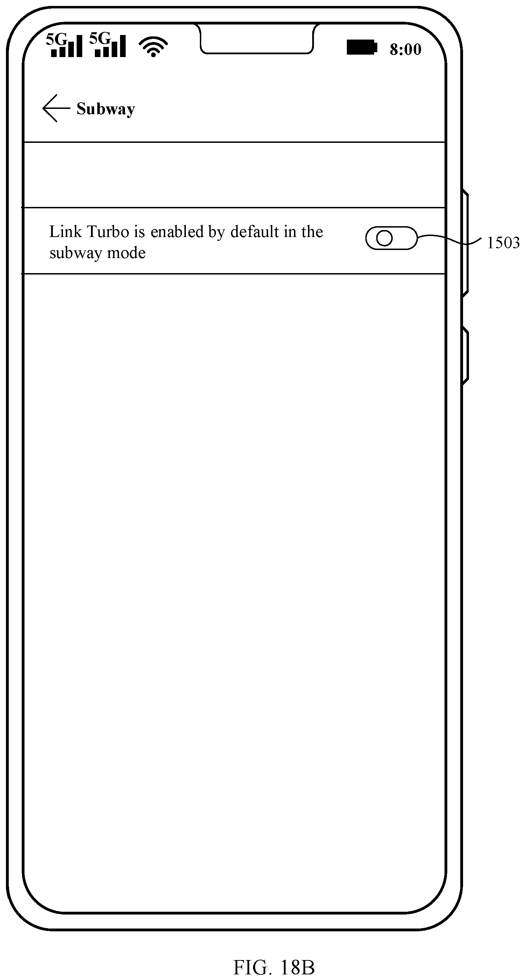

FIG. 18A and FIG. 18B are an example diagram of an interface of a setting option for smart travel. For example, the first setting interface may be shown in FIG. 18A, and the interface is a setting interface for smart travel. As shown in FIG. 18A, the setting interface for smart travel 1501 includes a subway setting 1502. Optionally, the setting interface for smart travel further includes a destination recommendation setting, a travel reminder setting, a hotel setting, and a flight setting.

It should be understood that the setting interface for smart travel may further include more setting functions about travel. This is merely an example for description, and this embodiment of this application is not limited thereto.

After the user taps the subway setting 1502 in FIG. 18A, an interface shown in FIG. 18B is displayed. For example, the subway setting interface may be the interface shown in FIG. 18B. The interface shown in FIG. 18B includes an on/off option 1503 (corresponding to the third option) for enabling Link Turbo by default in the subway mode. If the user selects the on option 1503, the Link Turbo function is automatically enabled after it is detected that the terminal user is in the state of getting on a subway. If the user selects the off option 1503, the Link Turbo function is not enabled after it is detected that the terminal user is in the state of getting on a subway.

It may be understood that the subway setting interface may further include another setting function. This is not specifically limited in this embodiment of this application.

Optionally, in a possible implementation, the detecting that the user uses the mobile phone includes but is not limited to the following manners:
detecting that the user opens an application APP; and
detecting that the mobile phone is switched from the screen-off state to the screen-on state for a period of time (for example, 10 seconds to 20 seconds).

It may be understood that the APP may be software that comes with the terminal, or may be a third-party APP (for example, an APP downloaded and installed by the user). The terminal may detect any type of APP that is opened.

For example, if the user opens a music APP, the network acceleration module is automatically enabled. In addition, a dialog box may further pop up in the notification bar, to remind the user that the network acceleration module is enabled. The dialog box may include a disable option or a continue to enable option.

Optionally, when the state of getting on a subway is intelligently determined, this embodiment of this application further provides a function of recommending transportation navigation (for example, urban public transportation navigation).

Optionally, in a possible implementation, when it is determined that the state of the terminal user is the state of getting on a subway, the method further includes:
displaying a second interface, where the second interface includes a first pop-up window, and the first pop-up window is used to recommend public transportation navigation to the user.

A type of an APP corresponding to the public transportation navigation recommended in the first pop-up window is not limited in this embodiment of this application. The APP may be public transportation navigation software, for example, public transportation navigation software that comes with the system or third-party public transportation navigation software downloaded by the user. Alternatively, the APP may be a map APP, for example, a map APP that comes with the system or a third-party map APP downloaded by the user.

Optionally, the public transportation navigation includes but is not limited to a public transportation mode such as a subway line, a bus line, or an inter-city line. In this way, the user can query or use public transportation by using the first pop-up window. This improves user experience.

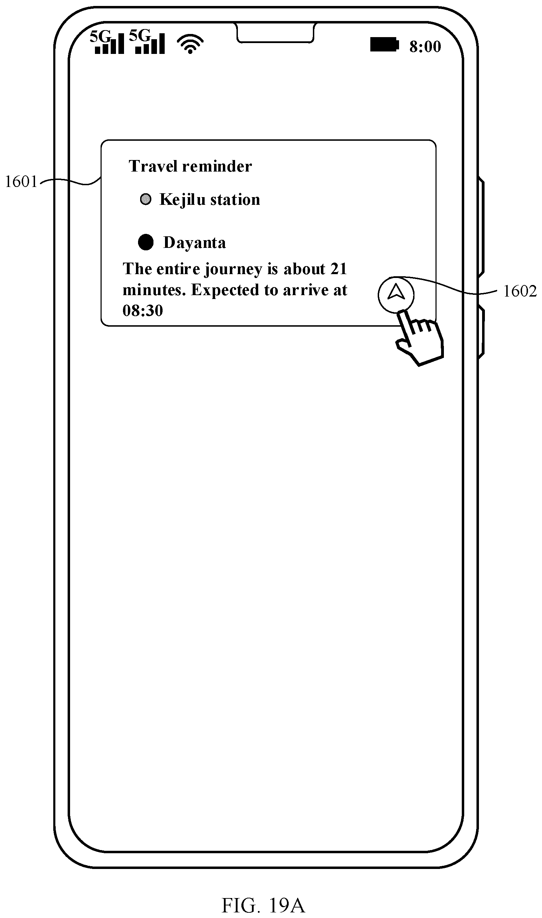

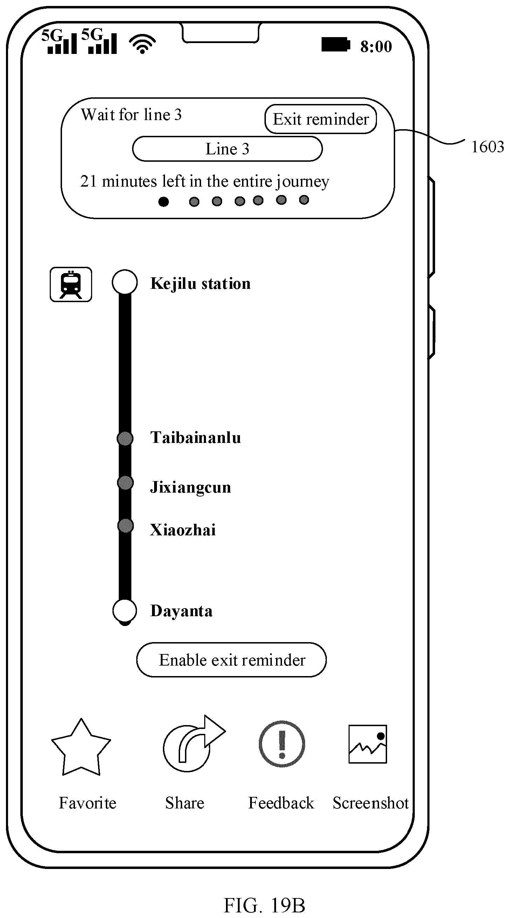

FIG. 19A and FIG. 19B are an example diagram of a recommendation interface presented in the state of getting on a subway. For example, the second interface may be an interface shown in FIG. 19A. As shown in FIG. 19A, the interface includes a travel reminder pop-up window 1601 (corresponding to the first pop-up window). If the user is currently at Kejilu station and a destination is Dayanta, a simple example of a recommended subway line map is displayed in the travel reminder pop-up window 1601. The pop-up window 1601 includes content such as a start station (for example, Kejilu station), a destination station (for example, Dayanta station), a time required for an entire journey (for example, 21 minutes), and an expected arrival time (for example, 8:30). In addition, the pop-up window 1601 further includes a control 1602. If the user taps the control 1602, detailed information about the recommended subway line map may be viewed. For example, an interface may be shown in FIG. 19B.

The interface shown in FIG. 19B shows passing subway stations from Kejilu station to Dayanta, for example, Kejilu station, Taibainanlu station, Jixiangcun station, Xiaozhai station, and Dayanta station. The user may learn, by using the interface shown in FIG. 19B, a detailed station map required for arriving at Dayanta station.

Optionally, the interface shown in FIG. 19B further includes a window 1603. Information such as a subway line (for example, line 3) corresponding to a current recommended route, a remaining time of the entire journey (for example, 21 minutes left in the entire journey), and an exit reminder option may be displayed in the window 1603.

Optionally, the interface shown in FIG. 19B further shows other options, for example, whether to enable exit reminder, a favorite option, a share option, a feedback option, and a screenshot option. If the user taps the favorite option, the recommended subway line may be stored. If the user taps the share option, the recommended subway line may be shared. If the user taps the feedback option, information about the recommended subway line may be fed back. If the user taps the screenshot, a screenshot of the current recommended subway line may be taken. If the user enables exit reminder, the user is reminded after arriving at the destination station.

It may be understood that the interface shown in FIG. 19B is merely an example for description, and this embodiment of this application is not limited thereto.

Optionally, after the user taps the control 1602, a jump to the map software that comes with the system may be made, or a jump to the third-party map software may be made. This is not specifically limited.

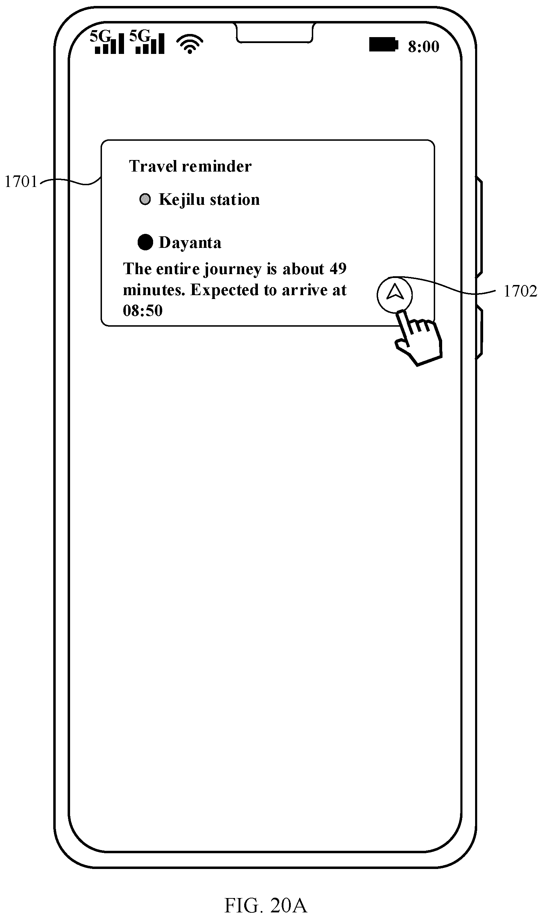

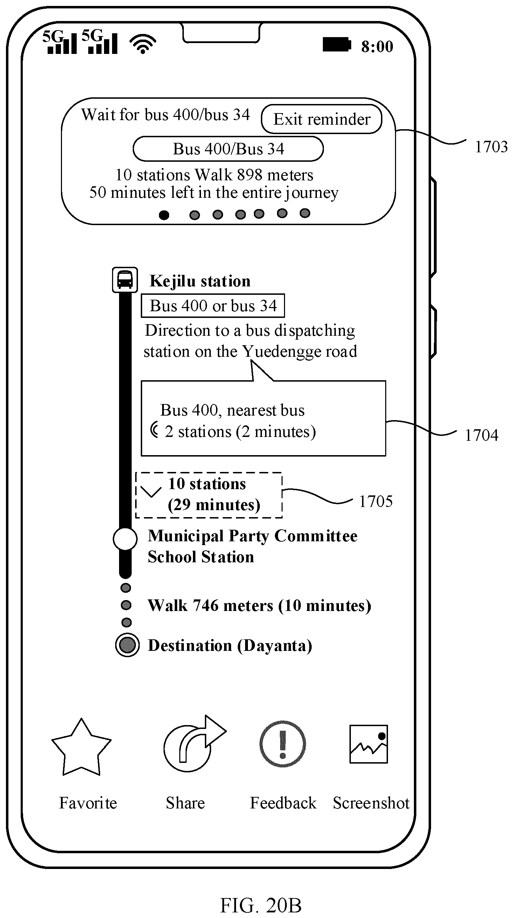

FIG. 20A and FIG. 20B are another example diagram of a recommendation interface presented in the state of getting on a subway. As shown in FIG. 20A, the interface includes a travel reminder pop-up window 1701. If the user is currently at Kejilu station and a destination is Dayanta, a simple example of a recommended bus line map is displayed in the travel reminder pop-up window 1701. The pop-up window 1701 includes content such as a start station (for example, Kejilu station), the destination (for example, Dayanta), a time required for an entire journey (for example, 49 minutes), and an expected arrival time (for example, 8:50). In addition, the pop-up window 1701 further includes a control 1702. If the user taps the control 1702, detailed information about the recommended bus line map may be viewed. For example, an interface may be shown in FIG. 20B.

Optionally, the interface shown in FIG. 20B further includes a window 1703. Information such as a bus line (for example, line 400 or 34) corresponding to a current recommended route, a quantity of passing bus stations (for example, 10 stations), a distance required for walking (for example, 898 meters), a remaining time of the entire journey (for example, 50 minutes left in the entire journey), and an exit reminder option may be displayed in the window 1703. If the user taps the exit reminder option, the user is reminded after arriving at the destination station.

The interface shown in FIG. 20B shows a detailed line map from Kejilu station to Dayanta. For example, to arrive at Dayanta, the user needs to take the bus line for 10 stations and then walk 746 meters. Optionally, the interface shown in FIG. 20B further includes a window 1704. The window 1704 may display related information about a recommended bus to the user. Optionally, the related information about a recommended bus includes information such as a quantity of nearest buses (for example, one bus line 400), a quantity of stations that need to pass to arrive at a destination (for example, two stations that need to pass to arrive at the destination), and an expected arrival time (for example, an expected arrival time of 2 minutes).

Optionally, the interface shown in FIG. 20B further includes a control 1705. The user may tap the control 1705 to view bus stations that pass from Kejilu station to Municipal Party Committee School station.

Optionally, the interface shown in FIG. 20B further shows other options, for example, a favorite option, a share option, a feedback option, and a screenshot option. If the user taps the favorite option, the recommended bus line may be stored. If the user taps the share option, the recommended bus line may be shared. If the user taps the feedback option, information about the recommended bus line may be fed back. If the user taps the screenshot, a screenshot of the current recommended bus line may be taken.

It may be understood that the interface shown in FIG. 20B is merely an example for description, and this embodiment of this application is not limited thereto.

Optionally, after the user taps the control 1702, a jump to the map software or the public transportation navigation software that comes with the system may be made, or a jump to the third-party public transportation navigation software (for example, a real-time bus APP) or subway software may be made. This is not specifically limited.

Optionally, when the state of getting on a subway is intelligently determined, this embodiment of this application further provides a function of recommending travel ride hailing.

Optionally, in a possible implementation, when it is determined that the state of the terminal user is the state of getting on a subway, the method further includes:
displaying a third interface, where the third interface includes a second pop-up window, and the second pop-up window is used to display a recommendation interface of a ride hailing application to the user.

A type of the ride hailing application is not limited in this embodiment of this application. The ride hailing application may be a ride hailing APP that comes with the system, or may be third-party travel software downloaded by the user, for example, Didi Chuxing, Meituan Chuxing, Hello Chuxing, Baidu Chuxing, or Gaode Chuxing.

Optionally, the second pop-up window may include a start point input bar and a destination input bar. A start point in the start point input bar may be automatically filled based on a current location point, or may be manually entered by the user. This is not limited. A destination in the destination input bar may be manually entered by the user, may be filled based on historical information (for example, a location frequently visited by the user or a destination that the user arrives at last time), or may be recommended based on a nearby popular scenic spot. This is not limited.

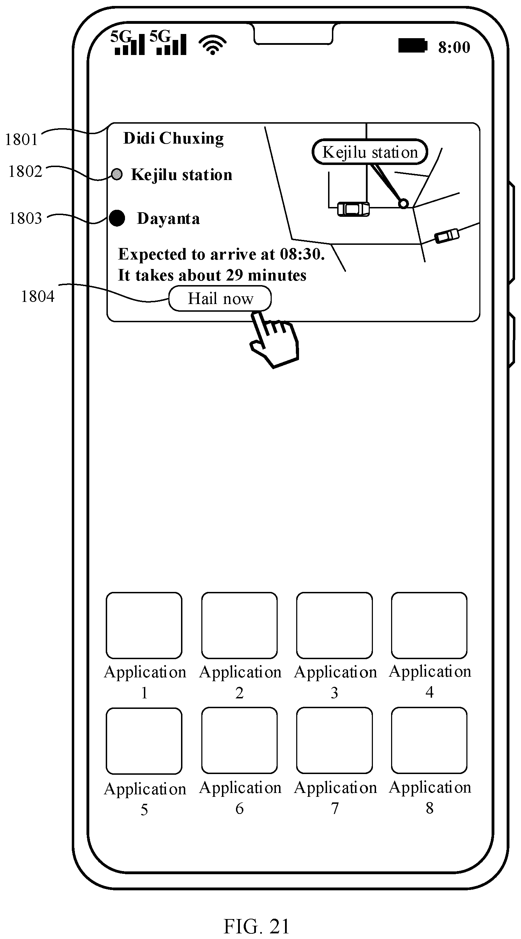

FIG. 21 is an example diagram of another interface presented in the state of getting on a subway according to an embodiment of this application. The third interface may be the interface shown in FIG. 21. As shown in FIG. 21, the interface includes a pop-up window 1801 of Didi Chuxing. The pop-up window 1801 includes a start point input bar 1802. For example, if the mobile phone is currently located at Kejilu station, Kejilu station is displayed in the start point input bar 1802. The pop-up window 1801 includes a destination point input bar 1803. For example, if the user manually enters Dayanta, Dayanta is displayed in the destination point input bar 1803. The pop-up window 1801 includes a hail now option 1804. If the user taps "hail now", a ride hailing service may be provided for the user.

The pop-up window 1801 may further include other information. For example, a real-time map is displayed in an upper-right area of the pop-up window 1801. The real-time map includes information such as a current location point (Kejilu station), a nearest available vehicle in a surrounding area, and a map of the current location.

Optionally, FIG. 21 may further include icon display of other applications, for example, an application 1, an application 2, ..., and an application 8. This is not specifically limited in this embodiment of this application.

It may be understood that the interface shown in FIG. 21 is merely an example for description, and this embodiment of this application is not limited thereto. Actually, the pop-up window 1801 may further include more information.

It may be further understood that in FIG. 21, the pop-up window of Didi Chuxing is merely used as an example for description, and this embodiment of this application is not limited thereto. Actually, other ride hailing software is also applicable to this embodiment of this application.

Optionally, when the state of getting on a subway is intelligently determined, a subway line map may be further displayed to the user.

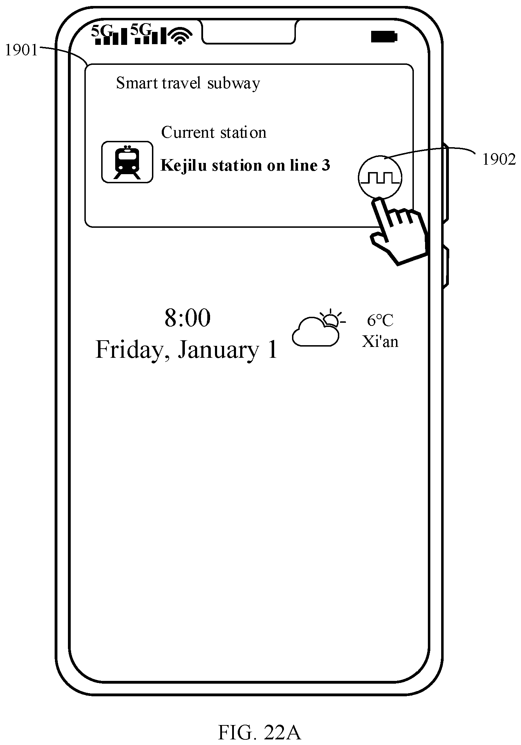

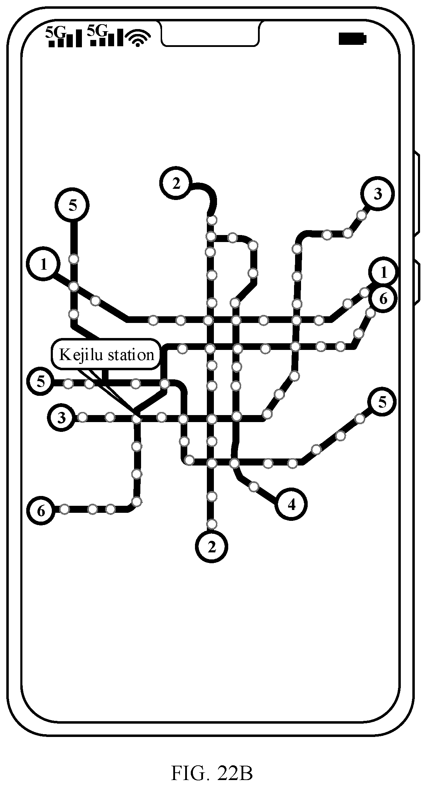

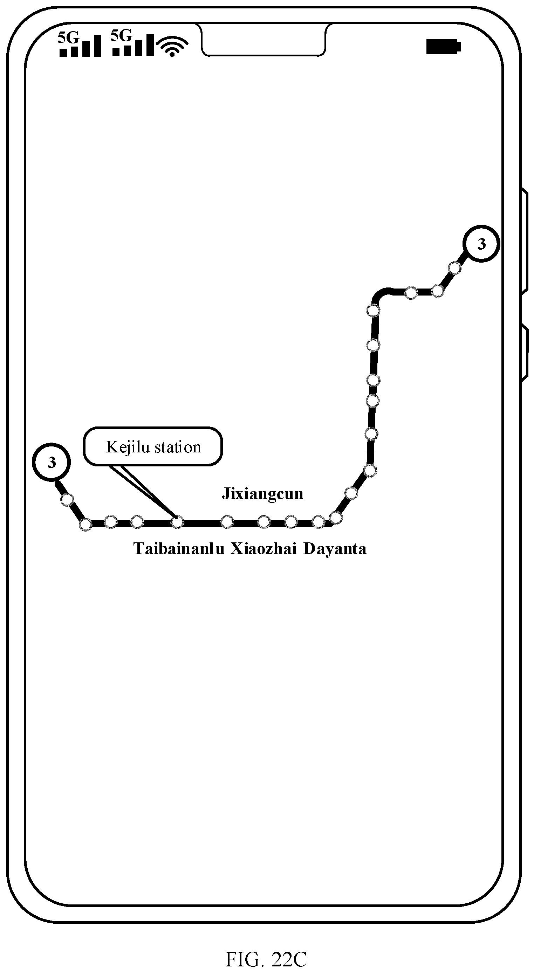

FIG. 22A, FIG. 22B, and FIG. 22C are an example diagram of still another interface presented in the state of getting on a subway according to an embodiment of this application. In an interface shown in FIG. 22A, after it is detected that the user enters the subway carriage, a window 1901 may pop up. A current line and a station (for example, a line 3 subway station) may be displayed in the window 1901. Optionally, the window 1901 may further include a control 1902. The control 1902 is an entry to the subway line map. After the user taps the control 1902, interface display of the subway line map may be entered. The subway line map may be all subway line maps, or may be a line map of a subway line on which the current station is located.

In a possible implementation, after the user taps the control 1902, an interface shown in FIG. 22B may be displayed. The interface shown in FIG. 22B shows all subway line maps of Xi'an, for example, line 1, line 2, line 3, line 4, line 5, and line 6. It should be understood that the interface shown in FIG. 22B is merely a simplified example for description. Actually, in an actual interface, subway station names corresponding to each subway line may be displayed together in the interface, to facilitate viewing by the user. It should be further understood that all the subway line maps of Xi'an shown in FIG. 22B are merely examples for descriptions, and do not constitute a limitation on this embodiment of this application. A specific line may be subject to an actual line.

In addition, a subway station (for example, Kejilu station on line 3) at which the user is currently located may be further displayed in the interface shown in FIG. 22B, so that the user learns of a current location of the user in real time.

In a possible implementation, after the user taps the control 1902, an interface shown in FIG. 22C may be displayed. The interface shown in FIG. 22C is a line map of the subway line on which the current station is located. It should be understood that the interface shown in FIG. 22C is merely a simplified example for description. Actually, in an actual interface, all subway station names corresponding to the subway line may be displayed together in the interface, to facilitate viewing by the user. In addition, a subway station at which the user is currently located may be further displayed in the interface shown in FIG. 22C, so that the user learns of a current location of the user in real time.

It should be understood that the interface in FIG. 22A, FIG. 22B, and FIG. 22C is merely an example for description, and this embodiment of this application is not limited thereto.

It should be further understood that in the foregoing interface, only an example in which the city in which the user is located is Xi'an is used for description. If the user is located in another city, this is also applicable.

Optionally, in a possible implementation, whether the user exits the subway station may be further detected based on location information. After it is detected that the user exits the subway station (for example, the boarding code is swiped to exit the station), a transportation navigation function, for example, a ride hailing function (for example, the interface shown in FIG. 21) or a travel recommendation function (for example, the interface shown in FIG. 19A and FIG. 19B or FIG. 20A and FIG. 20B), is recommended to the user.

It should be understood that the example diagrams of the mobile phone interfaces shown in this embodiment of this application are merely for ease of understanding by a person skilled in the art, and are not intended to limit this embodiment of this application to specific example scenarios.

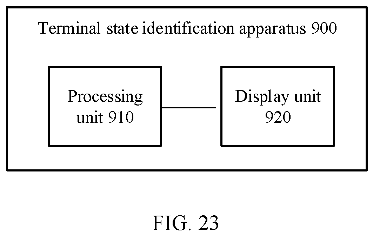

The terminal state identification method provided in the embodiments of this application is described in detail above with reference to FIG. 1 to FIG. 22A, FIG. 22B, and FIG. 22C. An apparatus embodiment of this application is described in detail below with reference to FIG. 23. It should be understood that the terminal state identification apparatus in the embodiments of this application may perform the embodiments of the various terminal state identification methods in the embodiments of this application. That is, for specific working processes of the following products, refer to the corresponding processes in the foregoing method embodiments.

FIG. 23 is a schematic block diagram of a terminal state identification apparatus 900 according to an embodiment of this application. As shown in FIG. 23, the apparatus 900 includes a processing unit 910 and a display unit 920.

It should be understood that the apparatus 900 may perform the terminal state identification method shown in FIG. 5 to FIG. 22A, FIG. 22B, and FIG. 22C. In a possible example, the apparatus 900 may be a terminal device.

In a possible example, the processing unit 910 is configured to: obtain acceleration data of a terminal by using an acceleration sensor;
obtain magnetometer data of the terminal by using a magnetometer sensor;
determine a first probability value based on the acceleration data and the magnetometer data, where the first probability value is used to represent a probability that the terminal is in a subway state, and when the first probability value is greater than a first probability threshold, the terminal is in the subway state;
determine a state of a terminal user based on the first probability value, where the state of the terminal user includes a state of getting off a subway and a state of getting on a subway; and
when determining that the terminal user is in the state of getting off a subway, invoke the display unit 920 to display a first interface, where the first interface includes a first window, and the first window is used to display a travel card.

Optionally, in a possible implementation, the method further includes:
enabling a network acceleration module when determining that the terminal user is in the state of getting on a subway.

Optionally, in a possible implementation, the processing unit 910 is further configured to:
determine a second probability value based on the acceleration data, where the second probability value is used to represent a probability that the terminal user is in a walking state, and when the second probability value is greater than a second probability threshold, the terminal user is in the walking state; and
determine the state of the terminal user based on the first probability value and the second probability value.

Optionally, in a possible implementation, the processing unit 910 is further configured to:
obtain a plurality of first probability values in first preset duration;
obtain, based on the plurality of first probability values, first duration that is in the first preset duration and in which the terminal is in the subway state;
determine whether the first duration is less than a first time threshold; and
when the first duration is less than the first time threshold, determine that the terminal user is in the state of getting off a subway.

Optionally, in a possible implementation, the processing unit 910 is further configured to:
determine whether the first duration is greater than a second time threshold; and
when the first duration is greater than the second time threshold, determine that the terminal user is in the state of getting on a subway.

Optionally, in a possible implementation, the processing unit 910 is further configured to:
obtain a plurality of first probability values in second preset duration;
obtain, based on the plurality of first probability values, second duration that is in the second preset duration and in which the terminal user is in the subway state;
determine whether the second duration is less than a third time threshold;
obtain a plurality of second probability values in third preset duration;
obtain, based on the plurality of second probability values, third duration that is in the third preset duration and in which the terminal user is in the walking state;
determine whether the third duration is greater than a fourth time threshold; and
when the second duration is less than the third time threshold, and the third duration is greater than the fourth time threshold, determine that the terminal user is in the state of getting off a subway.

Optionally, in a possible implementation, the processing unit 910 is further configured to:
obtain a plurality of first probability values in second preset duration;
obtain, based on the plurality of first probability values, second duration that is in the second preset duration and in which the terminal user is in the subway state;
determine whether the second duration is greater than a fifth time threshold;
obtain a plurality of second probability values in fourth preset duration;
obtain, based on the plurality of second probability values, fourth duration that is in the fourth preset duration and in which the terminal user is in the walking state;
determine whether the fourth duration is greater than a sixth time threshold; and
when the fourth duration is greater than the sixth time threshold, and the second duration is greater than the fifth time threshold, determine that the terminal user is in the state of getting on a subway.

Optionally, in a possible implementation, the processing unit 910 is further configured to:
calculate the first probability value based on the acceleration data and the magnetometer data by using a first binary classification network.

Optionally, in a possible implementation, the determining a second probability value based on the acceleration data includes:
calculating the second probability value based on the acceleration data by using a second binary classification network.

Optionally, in a possible implementation, the processing unit 910 is further configured to:
after enabling the network acceleration module, invoke the display unit 920 to display a prompt box to the user, where the prompt box includes a first option and a second option, the first option is used to choose to disable the network acceleration module, and the second option is used to choose to continue to enable the network acceleration module.

Optionally, in a possible implementation, the processing unit 910 is further configured to: when determining that the state of the terminal user is the state of getting on a subway, invoke the display unit 920 to display a second interface, where the second interface includes a first pop-up window, and the first pop-up window is used to recommend public transportation navigation to the user.

Optionally, in a possible implementation, the processing unit 910 is further configured to: invoke the display unit 920 to display a first setting interface, where the first setting interface includes a subway setting control; and
enter a subway setting interface in response to an operation performed by the user on the subway setting control, where the subway setting interface includes a third option, and the third option is used to choose to enable or disable the network acceleration module in the subway state by default.

It should be understood that the apparatus 900 is embodied in a form of a functional unit. The term "unit" herein may be implemented in a form of software and/or hardware. This is not specifically limited in this embodiment of this application.

For example, the "unit" may be a software program, a hardware circuit, or a combination of a software program and a hardware circuit for implementing the foregoing functions. The hardware circuit may include an application-specific integrated circuit (application specific integrated circuit, ASIC), an electronic circuit, a processor (for example, a shared processor, a dedicated processor, or a processor group) and a memory for executing one or more software or firmware programs, an integrated logic circuit, and/or another proper component that can provide the foregoing functions. In a simple embodiment, a person skilled in the art may figure out that the apparatus 900 may use the form shown in FIG. 4. For example, the processing unit 910 is implemented by using a first detection module, a second detection module, and a subway mode determining module; and the display unit 920 is implemented by using a display driver.

A person of ordinary skill in the art may be aware that the units and the algorithm steps in the examples described with reference to the embodiments disclosed in this specification can be implemented by using electronic hardware or a combination of computer software and electronic hardware. Whether these functions are performed in a hardware or software manner depends on particular applications and design constraints of the technical solutions. A person skilled in the art may use different methods to implement the described functions for each specific application, but it should not be considered that such an implementation goes beyond the scope of this application.

This application further provides a computer program product. When the computer program product is executed by a processor, the method in any method embodiment of this application is implemented.

The computer program product may be stored in a memory, and is finally converted, by performing processing processes such as preprocessing, compiling, assembling, and linking, into an executable target file that can be executed by the processor.

This application further provides a computer-readable storage medium. The computer-readable storage medium stores a computer program. When the computer program is executed by a computer, the method in any method embodiment of this application is implemented. The computer program may be an advanced language program, or may be an executable target program.

The computer-readable storage medium may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and serves as an external cache. Through example descriptions but not limitative descriptions, many forms of RAMs are available, for example, a static random access memory (static RAM, SRAM), a dynamic random access memory (dynamic RAM, DRAM), a synchronous dynamic random access memory (synchronous DRAM, SDRAM), double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

A person of ordinary skill in the art may be aware that the units and the algorithm steps in the examples described with reference to the embodiments disclosed in this specification can be implemented by using electronic hardware or a combination of computer software and electronic hardware. Whether these functions are performed in a hardware or software manner depends on particular applications and design constraints of the technical solutions. A person skilled in the art may use different methods to implement the described functions for each specific application, but it should not be considered that such an implementation goes beyond the scope of this application.

It may be clearly understood by a person skilled in the art that for convenience and brevity of description, for specific working processes of the described system, apparatus, and unit, refer to the corresponding processes in the foregoing method embodiments. Details are not described herein again.

In several embodiments provided in this application, it should be understood that the disclosed system, apparatus, and method may be implemented in another manner. For example, the apparatus embodiments described above are merely examples. For example, the unit division is merely logical function division, and there may be another division manner in actual implementation. For example, a plurality of units or components may be combined or integrated into another system, or some features may be ignored or not performed. In addition, the displayed or discussed mutual couplings or direct couplings or communications connections may be implemented through some interfaces. The indirect couplings or communications connections between the apparatuses or units may be implemented in an electrical form, a mechanical form, or another form.

The units described as separate components may or may not be physically separated, and components displayed as units may or may not be physical units, that is, may be located in one place, or may be distributed on a plurality of network units. Some or all of the units may be selected based on actual requirements to achieve the objectives of the solutions in the embodiments.

In addition, the functional units in the embodiments of this application may be integrated into one processing unit, each of the units may exist alone physically, or two or more units may be integrated into one unit.

When the function is implemented in a form of a software functional unit and sold or used as an independent product, the function may be stored in a computer-readable storage medium. Based on such an understanding, the technical solutions of this application essentially, or the part contributing to the conventional technology, or some of the technical solutions may be embodied in a form of a software product. The computer software product is stored in a storage medium, and includes several instructions for instructing a computer device (which may be a personal computer, a server, a network device, or the like) to perform all or some of the steps of the methods described in the embodiments of this application. The storage medium includes any medium that can store program code, for example, a USB flash drive, a removable hard disk, a read-only memory ROM, a random access memory RAM, a magnetic disk, or an optical disc.

It should be understood that in the embodiments of this application, sequence numbers of the processes do not mean an execution sequence. The execution sequence of the processes should be determined based on functions and internal logic of the processes, and should not be construed as any limitation on the implementation processes of the embodiments of this application.

In addition, the terms "system" and "network" are usually used interchangeably in this specification. The term "and/or" in this specification is merely an association relationship for describing associated objects, and represents that three relationships may exist. For example, A and/or B may represent the following three cases: Only A exists, both A and B exist, and only B exists. In addition, the character "/" in this specification usually represents an "or" relationship between associated objects. For example, A/B may indicate A or B.

The terms (or numbers) "first", "second", and the like that appear in the embodiments of this application are merely used for the purpose of description, that is, used to distinguish between different objects, for example, different "probability values", and cannot be understood as an indication or implication of relative importance or an implicit indication of a quantity of indicated technical features. Therefore, a feature defined by "first", "second", or the like can explicitly or implicitly includes one or more features. In the descriptions of the embodiments of this application, "at least one" means one or more; "a plurality of" means two or more; and "at least one of the following" or a similar expression thereof indicates any combination of these items, including a single item or any combination of a plurality of items.

For example, unless otherwise specified, an expression that is similar to the expression "the item includes at least one of the following: A, B, and C" and that appears in the embodiments of this application usually means that the item may be any one of the following: A. B; C; A and B; A and C; B and C; A, B, and C; A and A; A, A, and A; A, A, and B; A, A, and C, and A, B, and B; A, C, and C; B and B, B, B, and B, B, B and C, and C and C; and C, C, and C, and another combination of A, B, and C. Three elements A, B, and C are used above as examples to illustrate an optional entry of the item. When the expression is "the item includes at least one of the following: A, B, ..., and X ", that is, when there are more elements in the expression, an applicable entry of the item may be obtained based on the foregoing rule.

In conclusion, the foregoing descriptions are merely example embodiments of the technical solutions of this application, and are not intended to limit the protection scope of this application.

## Claims

1. A terminal state identification method, comprising:
obtaining acceleration data of a terminal (11) by using an acceleration sensor (180E);
obtaining magnetometer data of the terminal (11) by using a magnetometer sensor;
determining a first probability value based on the acceleration data and the magnetometer data, wherein the first probability value is used to represent a probability that the terminal (11) is in a subway state, and when the first probability value is greater than a first probability threshold, the terminal (11) is in the subway state;
determining a state of a terminal user based on the first probability value, wherein the state of the terminal user comprises a state of getting off a subway and a state of getting on a subway, wherein
the determining a state of a terminal user based on the first probability value comprises:
obtaining a plurality of first probability values in first preset duration;
obtaining, based on the plurality of first probability values, first duration that is in the first preset duration and in which the terminal (11) is in the subway state;
determining whether the first duration is less than a first time threshold; and
when the first duration is less than the first time threshold, determining that the terminal user is in the state of getting off a subway; and
displaying a first interface when determining that the terminal user is in the state of getting off a subway, wherein the first interface comprises a first window, and the first window is used to display a travel card.

2. The method according to claim 1, wherein the method further comprises:
enabling a network acceleration module when determining that the terminal user is in the state of getting on a subway, wherein the network acceleration module is to accelerate a network connection or perform network optimization and to improve Internet access experiences of the user in the subway carriage.

3. The method according to claim 1 or 2, wherein the method further comprises:
determining a second probability value based on the acceleration data, wherein the second probability value is used to represent a probability that the terminal user is in a walking state, and when the second probability value is greater than a second probability threshold, the terminal user is in the walking state; and
the determining a state of a terminal user based on the first probability value comprises:
determining the state of the terminal user based on the first probability value and the second probability value.

4. The method according to claim 1, wherein the method further comprises:
determining whether the first duration is greater than a second time threshold; and
when the first duration is greater than the second time threshold, determining that the terminal user is in the state of getting on a subway.

5. The method according to claim 3, wherein the determining the state of the terminal user based on the first probability value and the second probability value comprises:
obtaining a plurality of first probability values in second preset duration;
obtaining, based on the plurality of first probability values, second duration that is in the second preset duration and in which the terminal user is in the subway state;
determining whether the second duration is less than a third time threshold;
obtaining a plurality of second probability values in third preset duration;
obtaining, based on the plurality of second probability values, third duration that is in the third preset duration and in which the terminal user is in the walking state;
determining whether the third duration is greater than a fourth time threshold; and
when the second duration is less than the third time threshold, and the third duration is greater than the fourth time threshold, determining that the terminal user is in the state of getting off a subway.

6. The method according to claim 3, wherein the determining the state of the terminal user based on the first probability value and the second probability value comprises:
obtaining a plurality of first probability values in second preset duration;
obtaining, based on the plurality of first probability values, second duration that is in the second preset duration and in which the terminal user is in the subway state;
determining whether the second duration is greater than a fifth time threshold;
obtaining a plurality of second probability values in fourth preset duration;
obtaining, based on the plurality of second probability values, fourth duration that is in the fourth preset duration and in which the terminal user is in the walking state;
determining whether the fourth duration is greater than a sixth time threshold; and
when the fourth duration is greater than the sixth time threshold, and the second duration is greater than the fifth time threshold, determining that the terminal user is in the state of getting on a subway.

7. The method according to any one of claims 1 to 6, wherein the determining a first probability value based on the acceleration data and the magnetometer data comprises:
calculating the first probability value based on the acceleration data and the magnetometer data by using a first binary classification network.

8. The method according to any one of claims 3 to 7, wherein the determining a second probability value based on the acceleration data comprises:
calculating the second probability value based on the acceleration data by using a second binary classification network.

9. The method according to any one of claims 2 to 8, wherein after the enabling a network acceleration module, the method further comprises:
displaying a prompt box to the user, wherein the prompt box comprises a first option and a second option, the first option is used to choose to disable the network acceleration module, and the second option is used to choose to continue to enable the network acceleration module.

10. The method according to any one of claims 1 to 9, wherein when it is determined that the state of the terminal user is the state of getting on a subway, the method further comprises:
displaying a second interface, wherein the second interface comprises a first pop-up window, and the first pop-up window is used to recommend public transportation navigation to the user.

11. The method according to any one of claims 1 to 10, wherein the method further comprises:
displaying a first setting interface, wherein the first setting interface comprises a subway setting control; and
entering a subway setting interface in response to an operation performed by the user on the subway setting control, wherein the subway setting interface comprises a third option, and the third option is used to choose to enable or disable the network acceleration module in the subway state by default.

12. An electronic device, comprising a processor (110) and a memory, wherein the processor (110) is coupled to the memory, the memory is configured to store a computer program, and when the computer program is executed by the processor (110), the electronic device is enabled to perform the method according to any one of claims 1 to 11.

13. A computer-readable storage medium, wherein the computer-readable storage medium stores a computer program, and when the computer program is executed by a processor (110), the processor (110) is enabled to perform the method according to any one of claims 1 to 11.

14. A chip, comprising a processor (110), wherein when the processor (110) executes instructions the processor (110) performs the method according to any one of claims 1 to 11.

## Patentansprüche

1. Verfahren zur Identifizierung des Terminalzustands, umfassend:
Erfassung von Beschleunigungsdaten eines Terminals (11) mittels eines Beschleunigungssensors (180E);
Erfassung von Magnetometerdaten des Terminals (11) mittels eines Magnetometersensors;
Bestimmung eines ersten Wahrscheinlichkeitswerts basierend auf den Beschleunigungsdaten und den Magnetometerdaten, wobei der erste Wahrscheinlichkeitswert dazu dient, die Wahrscheinlichkeit darzustellen, dass sich das Terminal (11) im U-Bahn-Zustand befindet; und wenn der erste Wahrscheinlichkeitswert größer als ein erster Wahrscheinlichkeits-Schwellenwert ist, befindet sich das Terminal (11) im U-Bahn-Zustand;
Bestimmung eines Zustands eines Terminalnutzers basierend auf dem ersten Wahrscheinlichkeitswert, wobei der Zustand des Terminalnutzers sowohl den Zustand "aus der U-Bahn aussteigen" als auch "in die U-Bahn einsteigen" umfasst; wobei
das Bestimmen des Zustands eines Terminalnutzers basierend auf dem ersten Wahrscheinlichkeitswert umfasst:
Erfassung mehrerer erster Wahrscheinlichkeitswerte innerhalb einer ersten vorgegebenen Dauer;
Ermittlung, basierend auf den mehreren ersten Wahrscheinlichkeitswerten, der ersten Dauer, die innerhalb der ersten vorgegebenen Dauer liegt und in der sich das Terminal (11) im U-Bahn-Zustand befindet;
Bestimmung, ob die erste Dauer kleiner als ein erster Zeit-Schwellenwert ist; und
wenn die erste Dauer kleiner als der erste Zeit-Schwellenwert ist, Bestimmen, dass sich der Terminalnutzer im Zustand des Aussteigens aus der U-Bahn befindet; und
Anzeige einer ersten Benutzeroberfläche, wenn bestimmt wird, dass sich der Terminalnutzer im Zustand des Aussteigens aus der U-Bahn befindet, wobei die erste Benutzeroberfläche ein erstes Fenster umfasst und das erste Fenster dazu dient, eine Fahrkarte anzuzeigen.

2. Das Verfahren gemäß Anspruch 1, wobei das Verfahren ferner umfasst:
Aktivierung eines Netzwerk-Beschleunigungsmoduls bei Feststellung, dass sich der Terminalnutzer im Zustand des Einsteigens in die U-Bahn befindet, wobei das Netzwerk-Beschleunigungsmodul dazu dient, eine Netzwerkverbindung zu beschleunigen oder Netzwerkoptimierung durchzuführen und das Interneterlebnis des Nutzers im U-Bahn-Waggon zu verbessern.

3. Das Verfahren gemäß Anspruch 1 oder 2, wobei das Verfahren ferner umfasst:
Bestimmung eines zweiten Wahrscheinlichkeitswerts basierend auf den Beschleunigungsdaten, wobei der zweite Wahrscheinlichkeitswert dazu dient, die Wahrscheinlichkeit darzustellen, dass sich der Terminalnutzer im Geh-Zustand befindet; und wenn der zweite Wahrscheinlichkeitswert größer als ein zweiter Wahrscheinlichkeits-Schwellenwert ist, befindet sich der Terminalnutzer im Geh-Zustand; und
das Bestimmen des Zustands eines Terminalnutzers basierend auf dem ersten Wahrscheinlichkeitswert umfasst:
Bestimmung des Zustands des Terminalnutzers basierend auf dem ersten und dem zweiten Wahrscheinlichkeitswert.

4. Das Verfahren gemäß Anspruch 1, wobei das Verfahren ferner umfasst:
festzustellen, ob die erste Dauer größer als ein zweiter Zeit-Schwellenwert ist; und
wenn die erste Dauer größer als der zweite Zeit-Schwellenwert ist, festzustellen, dass sich der Endbenutzer im Zustand des Einsteigens in die U-Bahn befindet.

5. Das Verfahren gemäß Anspruch 3, wobei die Ermittlung des Zustands des Endbenutzers basierend auf dem ersten und zweiten Wahrscheinlichkeitswert Folgendes umfasst:
Ermittlung einer Vielzahl von ersten Wahrscheinlichkeitswerten innerhalb einer zweiten voreingestellten Dauer;
Ermittlung, basierend auf der Vielzahl von ersten Wahrscheinlichkeitswerten, einer zweiten Dauer innerhalb der zweiten voreingestellten Dauer, in der sich der Endbenutzer im U-Bahn-Zustand befindet;
Feststellung, ob die zweite Dauer kleiner als ein dritter Zeit-Schwellenwert ist;
Ermittlung einer Vielzahl von zweiten Wahrscheinlichkeitswerten innerhalb einer dritten voreingestellten Dauer;
Ermittlung, basierend auf der Vielzahl von zweiten Wahrscheinlichkeitswerten, einer dritten Dauer innerhalb der dritten voreingestellten Dauer, in der sich der Endbenutzer im Geh-Zustand befindet;
Feststellung, ob die dritte Dauer größer als ein vierter Zeit-Schwellenwert ist; und
Wenn die zweite Dauer kleiner als der dritte Zeit-Schwellenwert ist und die dritte Dauer größer als der vierte Zeit-Schwellenwert ist, Feststellung, dass sich der Endbenutzer im Zustand des Aussteigens aus der U-Bahn befindet.

6. Das Verfahren gemäß Anspruch 3, wobei die Ermittlung des Zustands des Endbenutzers basierend auf dem ersten und zweiten Wahrscheinlichkeitswert Folgendes umfasst:
Ermittlung einer Vielzahl von ersten Wahrscheinlichkeitswerten innerhalb einer zweiten voreingestellten Dauer;
Ermittlung, basierend auf der Vielzahl von ersten Wahrscheinlichkeitswerten, einer zweiten Dauer innerhalb der zweiten voreingestellten Dauer, in der sich der Endbenutzer im U-Bahn-Zustand befindet;
Feststellung, ob die zweite Dauer größer als ein fünfter Zeit-Schwellenwert ist;
Ermittlung einer Vielzahl von zweiten Wahrscheinlichkeitswerten innerhalb einer vierten voreingestellten Dauer;
Ermittlung, basierend auf der Vielzahl von zweiten Wahrscheinlichkeitswerten, einer vierten Dauer innerhalb der vierten voreingestellten Dauer, in der sich der Endbenutzer im Geh-Zustand befindet;
Feststellung, ob die vierte Dauer größer als ein sechster Zeit-Schwellenwert ist; und
Wenn die vierte Dauer größer als der sechste Zeit-Schwellenwert ist und die zweite Dauer größer als der fünfte Zeit-Schwellenwert ist, Feststellung, dass sich der Endbenutzer im Zustand des Einsteigens in die U-Bahn befindet.

7. Verfahren nach einem der Ansprüche 1 bis 6, wobei das Bestimmen eines ersten Wahrscheinlichkeitswerts auf Grundlage der Beschleunigungsdaten und der Magnetometerdaten Folgendes umfasst:
Berechnung des ersten Wahrscheinlichkeitswerts basierend auf den Beschleunigungsdaten und den Magnetometerdaten unter Verwendung eines ersten binären Klassifikationsnetzwerks.

8. Verfahren nach einem der Ansprüche 3 bis 7, wobei das Bestimmen eines zweiten Wahrscheinlichkeitswerts auf Grundlage der Beschleunigungsdaten Folgendes umfasst:
Berechnung des zweiten Wahrscheinlichkeitswerts basierend auf den Beschleunigungsdaten unter Verwendung eines zweiten binären Klassifikationsnetzwerks.

9. Verfahren nach einem der Ansprüche 2 bis 8, wobei nach der Aktivierung eines Netzwerk-Beschleunigungsmoduls das Verfahren ferner Folgendes umfasst:
Anzeigen eines Eingabefensters für den Benutzer, wobei das Eingabefenster eine erste und eine zweite Option umfasst, wobei die erste Option dazu dient, das Netzwerk-Beschleunigungsmodul zu deaktivieren und die zweite Option dazu dient, es weiterhin aktiviert zu lassen.

10. Verfahren nach einem der Ansprüche 1 bis 9, wobei, wenn festgestellt wird, dass sich der Zustand des Endbenutzers im Zustand "Einsteigen in die U-Bahn" befindet, das Verfahren ferner Folgendes umfasst:
Anzeigen einer zweiten Benutzeroberfläche, wobei die zweite Benutzeroberfläche ein erstes Popup-Fenster umfasst und das erste Popup-Fenster dazu dient, dem Benutzer die öffentliche Verkehrs-Navigation zu empfehlen.

11. Verfahren nach einem der Ansprüche 1 bis 10, wobei das Verfahren ferner Folgendes umfasst:
Anzeigen einer ersten Einstellungsoberfläche, wobei die erste Einstellungsoberfläche ein U-Bahn-Einstellungssteuerung enthält; und
Aufrufen einer U-Bahn-Einstellungsoberfläche als Reaktion auf eine vom Benutzer ausgeführte Aktion am U-Bahn-Einstellungssteuerung, wobei die U-Bahn-Einstellungsoberfläche eine dritte Option umfasst und die dritte Option dazu dient, das Netzwerk-Beschleunigungsmodul im U-Bahn-Zustand standardmäßig zu aktivieren oder zu deaktivieren.

12. Elektronisches Gerät, mit einem Prozessor (110) und einem Speicher, wobei der Prozessor (110) mit dem Speicher verbunden ist, der Speicher so konfiguriert ist, dass ein Computerprogramm gespeichert wird, und wenn das Computerprogramm vom Prozessor (110) ausgeführt wird, ist das elektronische Gerät dazu eingerichtet, das Verfahren gemäß einem der Ansprüche 1 bis 11 auszuführen.

13. Computerlesbares Speichermedium, wobei das computerlesbare Speichermedium ein Computerprogramm speichert und wenn das Computerprogramm von einem Prozessor (110) ausgeführt wird, befähigt es den Prozessor (110), das Verfahren gemäß einem der Ansprüche 1 bis 11 auszuführen.

14. Ein Chip, umfassend einen Prozessor (110), wobei der Prozessor (110) beim Ausführen von Anweisungen das Verfahren gemäß einem der Ansprüche 1 bis 11 durchführt.

## Revendications

1. Procédé d'identification de l'état d'un terminal, comprenant :
l'obtention de données d'accélération d'un terminal (11) au moyen d'un capteur d'accélération (180E) ;
l'obtention de données du magnétomètre du terminal (11) au moyen d'un capteur magnétomètre ;
la détermination d'une première valeur de probabilité sur la base des données d'accélération et des données du magnétomètre, la première valeur de probabilité étant utilisée pour représenter une probabilité que le terminal (11) soit en état de métro, et lorsque la première valeur de probabilité est supérieure à un premier seuil de probabilité, le terminal (11) est en état de métro ;
la détermination d'un état d'utilisateur du terminal sur la base de la première valeur de probabilité, l'état de l'utilisateur du terminal comprenant un état de descente du métro et un état de montée dans le métro, où
la détermination de l'état de l'utilisateur du terminal sur la base de la première valeur de probabilité comprend :
l'obtention d'une pluralité de premières valeurs de probabilité dans une première durée prédéfinie ;
l'obtention, sur la base de la pluralité de premières valeurs de probabilité, d'une première durée qui se situe dans la première durée prédéfinie et durant laquelle le terminal (11) est en état de métro ;
la détermination si la première durée est inférieure à un premier seuil de temps ; et
lorsque la première durée est inférieure au premier seuil de temps, la détermination que l'utilisateur du terminal est dans l'état de descente du métro ; et
l'affichage d'une première interface lors de la détermination que l'utilisateur du terminal est dans l'état de descente du métro, la première interface comprenant une première fenêtre, et la première fenêtre étant destinée à afficher une carte de transport.

2. Procédé selon la revendication 1, ledit procédé comprenant également :
l'activation d'un module d'accélération de réseau lors de la détermination que l'utilisateur du terminal est dans l'état de montée dans le métro, le module d'accélération de réseau étant destiné à accélérer la connexion réseau ou à effectuer une optimisation réseau, et à améliorer l'expérience d'accès à Internet de l'utilisateur dans la rame de métro.

3. Procédé selon la revendication 1 ou 2, ledit procédé comprenant également :
la détermination d'une seconde valeur de probabilité sur la base des données d'accélération, la seconde valeur de probabilité étant utilisée pour indiquer la probabilité que l'utilisateur du terminal soit dans un état de marche, et lorsque la seconde valeur de probabilité est supérieure à un second seuil de probabilité, l'utilisateur du terminal est dans un état de marche ; et
la détermination de l'état de l'utilisateur du terminal sur la base de la première valeur de probabilité comprend :
la détermination de l'état de l'utilisateur du terminal sur la base de la première valeur de probabilité et de la seconde valeur de probabilité.

4. Le procédé selon la revendication 1, dans lequel le procédé comprend en outre :
déterminer si la première durée est supérieure à un second seuil temporel ; et
lorsque la première durée est supérieure au second seuil temporel, déterminer que l'utilisateur du terminal est dans l'état de montée dans le métro.

5. Le procédé selon la revendication 3, dans lequel la détermination de l'état de l'utilisateur du terminal sur la base de la première valeur de probabilité et de la deuxième valeur de probabilité comprend :
obtenir une pluralité de premières valeurs de probabilité dans une deuxième durée prédéfinie ;
obtenir, sur la base de la pluralité de premières valeurs de probabilité, une deuxième durée correspondant à la deuxième durée prédéfinie et dans laquelle l'utilisateur du terminal est dans l'état métro ;
déterminer si la deuxième durée est inférieure à un troisième seuil temporel ;
obtenir une pluralité de deuxièmes valeurs de probabilité dans une troisième durée prédéfinie ;
obtenir, sur la base de la pluralité de deuxièmes valeurs de probabilité, une troisième durée correspondant à la troisième durée prédéfinie et dans laquelle l'utilisateur du terminal est dans l'état marche ;
déterminer si la troisième durée est supérieure à un quatrième seuil temporel ; et
lorsque la deuxième durée est inférieure au troisième seuil temporel et que la troisième durée est supérieure au quatrième seuil temporel, déterminer que l'utilisateur du terminal est dans l'état de descente du métro.

6. Le procédé selon la revendication 3, dans lequel la détermination de l'état de l'utilisateur du terminal sur la base de la première valeur de probabilité et de la deuxième valeur de probabilité comprend :
obtenir une pluralité de premières valeurs de probabilité dans une deuxième durée prédéfinie ;
obtenir, sur la base de la pluralité de premières valeurs de probabilité, une deuxième durée correspondant à la deuxième durée prédéfinie et dans laquelle l'utilisateur du terminal est dans l'état métro ;
déterminer si la deuxième durée est supérieure à un cinquième seuil temporel ;
obtenir une pluralité de deuxièmes valeurs de probabilité dans une quatrième durée prédéfinie ;
obtenir, sur la base de la pluralité de deuxièmes valeurs de probabilité, une quatrième durée correspondant à la quatrième durée prédéfinie et dans laquelle l'utilisateur du terminal est dans l'état marche ;
déterminer si la quatrième durée est supérieure à un sixième seuil temporel ; et
lorsque la quatrième durée est supérieure au sixième seuil temporel et que la deuxième durée est supérieure au cinquième seuil temporel, déterminer que l'utilisateur du terminal est dans l'état de montée dans le métro.

7. Le procédé selon l'une quelconque des revendications 1 à 6, dans lequel la détermination d'une première valeur de probabilité sur la base des données d'accélération et des données du magnétomètre comprend :
calculer la première valeur de probabilité sur la base des données d'accélération et des données du magnétomètre en utilisant un premier réseau de classification binaire.

8. Le procédé selon l'une quelconque des revendications 3 à 7, dans lequel la détermination d'une seconde valeur de probabilité sur la base des données d'accélération comprend :
calculer la seconde valeur de probabilité sur la base des données d'accélération en utilisant un second réseau de classification binaire.

9. Le procédé selon l'une quelconque des revendications 2 à 8, dans lequel, après l'activation d'un module d'accélération de réseau, le procédé comprend en outre :
afficher une boîte de dialogue à l'utilisateur, la boîte de dialogue comportant une première option et une seconde option, la première option permettant de choisir de désactiver le module d'accélération de réseau, et la seconde option permettant de choisir de continuer à activer le module d'accélération de réseau.

10. Le procédé selon l'une quelconque des revendications 1 à 9, dans lequel, lorsqu'il est déterminé que l'état de l'utilisateur terminal est l'état de montée dans un métro, le procédé comprend en outre :
afficher une seconde interface, la seconde interface comportant une première fenêtre contextuelle, et la première fenêtre contextuelle étant destinée à recommander à l'utilisateur une navigation par transports publics.

11. Le procédé selon l'une quelconque des revendications 1 à 10, dans lequel le procédé comprend en outre :
afficher une première interface de réglage, la première interface de réglage comportant un contrôle de réglage du métro ; et
accéder à une interface de réglage du métro en réponse à une opération effectuée par l'utilisateur sur le contrôle de réglage du métro, ladite interface comprenant une troisième option, cette troisième option permettant de choisir d'activer ou de désactiver par défaut le module d'accélération de réseau en mode métro.

12. Un dispositif électronique, comprenant un processeur (110) et une mémoire, le processeur (110) étant couplé à la mémoire, la mémoire étant conçue pour stocker un programme informatique, et lorsque le programme informatique est exécuté par le processeur (110), le dispositif électronique étant apte à exécuter le procédé selon l'une quelconque des revendications 1 à 11.

13. Un support de stockage lisible par ordinateur, ledit support contenant un programme informatique, et lorsque le programme informatique est exécuté par un processeur (110), le processeur (110) étant apte à exécuter le procédé selon l'une quelconque des revendications 1 à 11.

14. Une puce, comprenant un processeur (110), dans laquelle, lorsque le processeur (110) exécute des instructions, le processeur (110) met en œuvre la méthode selon l'une quelconque des revendications 1 à 11.
